(19) Europäisches Patentamt
European Patent Office
Office européen des brevets

(11) **EP 4 610 138 A1**

(12) **EUROPEAN PATENT APPLICATION**
published in accordance with Art. 153(4) EPC

(43) Date of publication:
**03.09.2025 Bulletin 2025/36**

(21) Application number: **23882594.7**

(22) Date of filing: **23.10.2023**

(51) International Patent Classification (IPC):
*B60W 60/00* (2020.01)        *B60W 20/14* (2016.01)
*B60W 20/50* (2016.01)        *B60W 40/02* (2006.01)
*B60W 50/04* (2006.01)        *G06F 1/20* (2006.01)
*G06V 20/58* (2022.01)        *H01L 23/473* (2006.01)
*H05K 7/20* (2006.01)

(52) Cooperative Patent Classification (CPC):
**B60W 20/14; B60W 20/50; B60W 40/02;
B60W 50/04; B60W 60/00; G06F 1/20; G06V 20/58;
H01L 23/473; H05K 7/20**

(86) International application number:
**PCT/JP2023/038226**

(87) International publication number:
**WO 2024/090389 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.10.2022  JP 2022170165
27.10.2022  JP 2022172777
01.11.2022  JP 2022175679
11.11.2022  JP 2022181362
14.11.2022  JP 2022182131
21.11.2022  JP 2022186040
24.11.2022  JP 2022187648
24.11.2022  JP 2022187649**

**28.11.2022  JP 2022189546
27.12.2022  JP 2022210884
09.03.2023  JP 2023036967
09.03.2023  JP 2023036975
10.05.2023  JP 2023078024
15.05.2023  JP 2023080388**

(71) Applicant: **SoftBank Group Corp.
Tokyo 105-7537 (JP)**

(72) Inventor: **SON, Masayoshi
Tokyo 105-7537 (JP)**

(74) Representative: **DREISS Patentanwälte PartG
mbB
Friedrichstraße 6
70174 Stuttgart (DE)**

(54) **COOLING EXECUTION DEVICE, COOLING EXECUTION METHOD, COOLING EXECUTION PROGRAM, AND VEHICLE**

(57)    The cooling execution device includes: an acquisition unit that acquires a detection result of detecting an object related to operation of a control device mounted on a vehicle, the control device controlling autonomous driving of the vehicle; and an execution unit that performs cooling of the control device based on the detection result.

EP 4 610 138 A1

# FIG.1

**Description**

Technical Field

The present invention relates to a cooling execution device, a cooling execution method, a cooling execution program, and a vehicle.

Background Art

Japanese Patent Application Laid-Open (JP-A) No. 2022-035198 describes a vehicle having an autonomous driving function.

SUMMARY OF INVENTION

Solution to Problem

According to an embodiment of the present disclosure, a cooling execution device includes: an acquisition unit that acquires a detection result of detecting an object related to operation of a control device mounted on a vehicle, the control device controlling autonomous driving of the vehicle; and an execution unit that is configured to performs cooling of the control device based on the detection result.

In the cooling execution device, the acquisition unit may extract, as the detection result, a point indicating an existence position of the object from an image of one frame of the object, and acquire motion information indicating a motion of the point indicating the existence position of the object along a predetermined coordinate axis at a frame rate of 100 frames/second or higher.

Any cooling execution device may further include a prediction unit that predicts the operation of the control device by using the detection result, in which the prediction unit may predict the operation of the control device by using a learning model generated by machine learning using, as learning data, the detection result and an operation status of the control device when the detection result is acquired.

In any cooling execution device, the prediction unit may further predict a temperature change of each of a plurality of portions in the control device, and the execution unit may control cooling of the portion in the control device.

Any cooling execution device may include: an acquisition unit that acquires a detection result for an object from an information processing device, the information processing device being configured to output point information representing the object as a point in images of the object captured by a plurality of cameras oriented in corresponding directions and to putout identification information for identifying the object and associate the point information with the identification information; and an execution unit that is configured to perform cooling of the information processing device based on the detection result acquired by the acquisition unit.

In any cooling execution device, the execution unit may cause the cooling of the information processing device to be stopped in a case where a predetermined condition is satisfied.

In any cooling execution device, the execution unit may cause the cooling of the information processing device to be stopped in a case where a condition that the object detected by the information processing device is no longer detected as the predetermined condition is satisfied.

In any cooling execution device, the execution unit may cause the cooling of the information processing device to be stopped in a case where a condition that the object detected by the information processing device is moving toward an outside of a detection range as the predetermined condition is satisfied.

In any cooling execution device, the execution unit may cause the cooling of the information processing to be stopped device after a predetermined time elapses in a case where the predetermined condition is satisfied.

Any cooling execution device may further include a prediction unit that predicts an operation status of the information processing device based on the detection result acquired by the acquisition unit, in which the execution unit may perform the cooling of the information processing device based on a prediction result for the operation status of the information processing device from the prediction unit.

In any cooling execution device, the prediction unit may predict a temperature change of the information processing device, and the execution unit may perform the cooling of the information processing device by using cooling means corresponding to a prediction result for the temperature change of the information processing device from the prediction unit.

In any cooling execution device, the prediction unit may predict a time when a temperature of the information processing device becomes equal to or lower than a threshold, and the execution unit may cause the cooling of the information processing device to be stopped in a case where a condition that the time predicted by the prediction unit is reached as the predetermined condition is satisfied.

In any cooling execution device, the detection result acquired by the acquisition unit may be the point information.

Any cooling execution device may further include: a prediction unit that predicts an operation status and a temperature change of the information processing device based on the detection result acquired by the acquisition unit; and an execution unit that performs the cooling of the information processing device based on a prediction result for the operation status of the information processing device from the prediction unit and adjusts a cooling amount for the information processing device based on a prediction result for the temperature change of the information processing device from the prediction unit.

In any cooling execution device, the prediction unit may further predict a peak of a temperature of the information processing device, and the execution unit may perform the cooling of the information processing device with a cooling amount corresponding to the peak of the temperature predicted by the prediction unit.

In any cooling execution device, the execution unit may perform the cooling of the information processing device such that the cooling amount corresponding to the peak of the temperature is obtained before reaching the peak of the temperature predicted by the prediction unit.

In any cooling execution device, the information processing device may be mounted on a movable body, the prediction unit predicts that the temperature of the information processing device rises in a case where the object is making a motion of approaching the movable body in the detection result, and the execution unit may increase the cooling amount for the information processing device in a case where a temperature rise of the information processing device is predicted by the prediction unit.

According to an embodiment of the disclosure, a cooling execution method executed by a computer is provided. The cooling execution method may include: acquiring a detection result of detecting an object related to operation of a control device mounted on a vehicle, the control device controlling autonomous driving of the vehicle; and performing cooling of the control device based on the detection result.

According to an embodiment of the disclosure, there is provided a cooling execution program for causing a computer to execute processing. The cooling execution program may cause the computer to execute processing of: acquiring a detection result of detecting an object related to operation of a control device mounted on a vehicle, the control device controlling autonomous driving of the vehicle; and performing cooling of the control device based on the detection result.

According to an embodiment of the disclosure, there is provided a vehicle including a control device that controls autonomous driving, the vehicle including: a power unit including a motor; an acquisition unit that acquires a detection result of detecting an object related to operation of the control device; and an execution unit that performs cooling of the control device based on the detection result, in which the control device controls each unit of the vehicle including the cooling by regenerative power generated by the motor at a time of deceleration of the vehicle according to the detection result.

In any vehicle, the control device may control a deceleration of the vehicle such that each unit of the vehicle is controlled only using the regenerative power from when the deceleration of the vehicle according to the detection result is started to when the vehicle stops.

Any vehicle may further include a brake actuator that performs a brake operation of the vehicle, in which the control device may control the brake actuator using the regenerative power at a time of the deceleration of the vehicle according to the detection result.

Any vehicle may further include a steering actuator that performs a steering operation of the vehicle, in which the control device may control the steering actuator using the regenerative power at a time of the deceleration of the vehicle according to the detection result.

In any vehicle, the acquisition unit may extract, as the detection result, a point indicating an existence position of the object from an image of one frame of the object, and acquire motion information indicating a motion of the point indicating the existence position of the object along a predetermined coordinate axis at a frame rate of 100 frames/second or higher.

Any vehicle may further include a prediction unit that predicts the operation of the control device by using the detection result, in which the prediction unit may predict the operation of the control device by using a learning model generated by machine learning using, as learning data, the detection result and an operation status of the control device when the detection result is acquired.

In any vehicle, the prediction unit may further predict a temperature change of each of a plurality of portions in the control device, and the execution unit may control cooling of the portion in the control device.

Note that the summary of the invention described above does not enumerate all the necessary features of the invention. Further, a sub-combination of these feature groups can also be the invention.

BRIEF DESCRIPTION OF DRAWINGS

Fig. 1 schematically shows an example of a system 1.

Fig. 2 is an explanatory diagram for describing a learning phase in the system 1.

Fig. 3 is an explanatory diagram for describing a cooling execution phase in the system 1.

Fig. 4 schematically shows an example of an SoCBox 400 and a cooling unit 600.

Fig. 5 schematically shows an example of the SoCBox 400 and the cooling unit 600.

Fig. 6 schematically shows an example of the SoCBox 400 and the cooling unit 600.

Fig. 7 schematically shows a vehicle according to a modification.

Fig. 8 is a schematic diagram showing an example of a vehicle on which a central brain is mounted.

Fig. 9 is a first block diagram showing an example of a configuration of an information processing device.

Fig. 10 is a second block diagram showing an example of a configuration of an information processing device.

Fig. 11 is an explanatory diagram showing an example of point information output from a motion processing unit (MoPU).

Fig. 12 is a third block diagram showing an example of a configuration of an information processing device.

Fig. 13 is a fourth block diagram showing an example of a configuration of an information processing device.

Fig. 14 is an explanatory diagram showing an example of association between point information and label information.

Fig. 15 is an explanatory diagram showing a schematic configuration of a vehicle.

Fig. 16 is a block diagram showing an example of a functional configuration of a cooling execution device.

Fig. 17 is a fifth block diagram showing an example of a configuration of an information processing device.

Fig. 18 is a sixth block diagram showing an example of a configuration of the information processing device.

Fig. 19 is a diagram schematically showing coordinate detection in time series for an object.

Fig. 20 is a seventh block diagram showing an example of a configuration of an information processing device.

Fig. 21 is an explanatory diagram for describing an image of an object captured by an event camera.

Fig. 22 is an explanatory diagram schematically showing an example of a hardware configuration of a computer that functions as a management server, the SoCBox, the information processing device, or the cooling execution device.

DESCRIPTION OF EMBODIMENTS

Hereinafter, the present invention will be described through embodiments of the invention, but the following embodiments do not limit the invention according to the claims. In addition, not all combinations of features described in the embodiments are essential to the solution of the invention.

(First Embodiment)

Heat generation is a problem when a system on chip (SoC) for autonomous driving executes advanced arithmetic processing. Therefore, in the present embodiment, there is provided a cooling execution device that detects operation of processing in an SoCBox and executes cooling of the SoCBox.

In some cases, a mobile object present on a roadway may be detected as a trigger for operation of the SoCBox. For example, in a case where the mobile object present on the roadway is detected during autonomous driving, the SoCBox may execute arithmetic processing for controlling a vehicle with respect to the object. However, since a temperature of the SoCBox immediately becomes high, it is difficult to perform advanced arithmetic operation in the vehicle (a problem for fully autonomous driving). Therefore, it is conceivable to predict heat dissipation due to the operation of the SoCBox and cool the SoCBox by detecting the mobile object or the like present on the roadway. For example, the heat dissipation of the SoCBox is predicted by detecting the mobile object or the like, and cooling is performed simultaneously with the heat dissipation, thereby preventing the temperature of the SoCBox from becoming high and enabling the advanced arithmetic operation in the vehicle.

The heat dissipation of the SoCBox is predicted by detecting the mobile object or the like, and cooling is performed simultaneously with the heat dissipation, thereby preventing the temperature of the SoCBox from becoming high and enabling the advanced arithmetic operation in the vehicle.

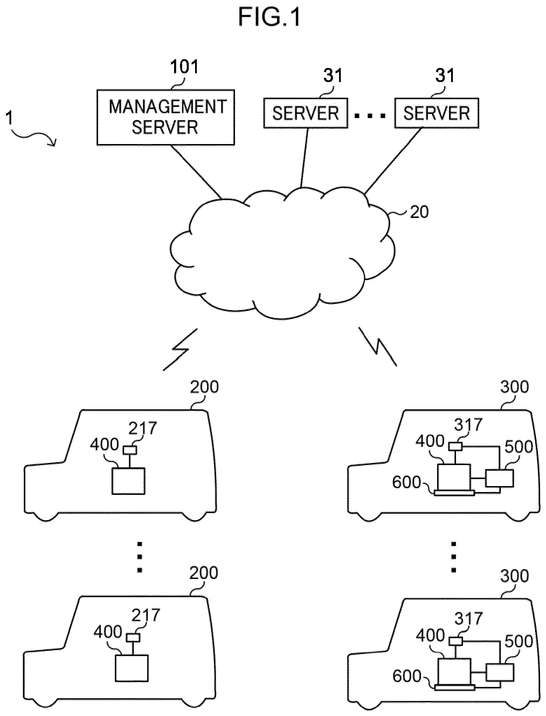

Fig. 1 schematically shows an example of a system 1. The system 1 includes a management server 101, an SoCBox 400, a cooling execution device 500, and a cooling unit 600.

The SoCBox 400, the cooling execution device 500, and the cooling unit 600 are mounted on a vehicle. The SoCBox 400 controls autonomous driving of the vehicle using sensor values of a plurality of sensors mounted on the vehicle. Since a very high processing load is applied to autonomous driving control of the vehicle, the SoCBox 400 may have a very high temperature. In a case where the SoCBox 400 has an excessively high temperature, there is a possibility that the SoCBox 400 is not normally operated, and the vehicle is adversely affected.

For example, the cooling execution device 500 according to the embodiment predicts operation of the SoCBox 400 and starts cooling of the SoCBox 400 based on the operation. For example, in a case where a mobile object that is a factor of the operation of the SoCBox 400 is detected, the cooling execution device 500 immediately starts the cooling of the SoCBox 400. By starting the cooling earlier than the start of heat generation due to the operation of the SoCBox 400 or at the same time as the start of the heat generation, it is possible to reliably prevent the temperature of the SoCBox 400 from becoming high.

The cooling execution device 500 may predict the operation of the SoCBox 400 by AI. The operation of the SoCBox 400 may be learned by using data collected by a vehicle 200. For example, the management server 101 collects the data from the vehicle 200 and performs the learning. A subject that performs the learning is not limited to the management server 101, and may be another device.

The SoCBox 400 and a motion processing unit (MoPU) 217 as a sensor are mounted on the vehicle 200. The SoCBox 400 controls autonomous driving of the vehicle 200 by using sensor values of a plurality of sensors including the MoPU 217 mounted on the vehicle 200 and external information received from a plurality of types of servers 31.

Here, the MoPU 217 can be built in a low-resolution camera (not shown) installed in the vehicle. The MoPU 217 outputs motion information indicating a motion of an imaged object at a frame rate of 100 frames/second, for example. The MoPU 217 outputs, as the motion information, vector information of a motion of a point indicating an existence position of the object along a predetermined coordinate axis. That is, the motion information output from the MoPU 217 does not include information necessary for identifying what the imaged object is (for example, whether the imaged object is a person or an obstacle), and includes only information indicating a motion (a movement direction and a movement speed) of a center point (or a center-of-gravity point) of the object on a coordinate axis (an x axis, a y axis, or a z axis).

The server 31 may be an example of an external device. Examples of the plurality of types of servers 31 include servers that provide traffic information, servers that provide weather information, and the like. The SoCBox 400 transmits, to the management server 101, a sensor value including a detection result of the MoPU 217, the external information, and the like used for control of the autonomous driving, an operation status of the SoCBox 400 at the time of control, and a temperature change of the SoCBox 400 at the time of control.

The management server 101 performs the learning by using the information received from one or more SoCBoxes 400 and the plurality of sensors. The management server 101 performs machine learning using, as learning data, the detection results of the MoPU 217 acquired by the SoCBox 400 and the operation status of the SoCBox 400 when the SoCBox 400 acquires these pieces of information, thereby generating a learning model that receives the information acquired by the SoCBox 400 and outputs the operation status of the SoCBox 400.

A vehicle 300 is a vehicle having a cooling function according to the embodiment. An MoPU 217 as a sensor, an SoCBox 400, a cooling execution device 500, and a cooling unit 600 are mounted on the vehicle 300. The cooling execution device 500 may receive the learning model generated by the management server 101 from the management server 101 and store the learning model.

The cooling execution device 500 may acquire sensor values of a plurality of sensors including a detection result of the MoPU 217 mounted on the vehicle 300 from the plurality of sensors or from the SoCBox 400, and may start cooling of the SoCBox 400 by the cooling unit 600 in a case where operation of the SoCBox 400 is predicted. Specifically, in a case where the mobile object or the like is detected as the detection result of the MoPU 217, the cooling execution device 500 predicts that the SoCBox 400 operates, and starts the cooling of the SoCBox 400 by the cooling unit 600.

Furthermore, the cooling execution device 500 may acquire the sensor values of the plurality of sensors including the detection result of the MoPU 217 mounted on the vehicle 300 from the plurality of sensors or from the SoCBox 400, and input the acquired information to the learning model to predict the operation of the SoCBox 400.

The SoCBox 400, the cooling execution device 500, the management server 101, and the server 31 may communicate via a network 20. The network 20 may include a vehicle network. The network 20 may include the Internet. The network 20 may include a local area network (LAN). The network 20 may include a mobile communication network. The mobile communication network may conform to any one of a 5th generation (5G) communication scheme, a long term evolution (LTE) communication scheme, a 3rd generation (3G) communication scheme, and a subsequent communication scheme including a 6th generation (6G) communication scheme.

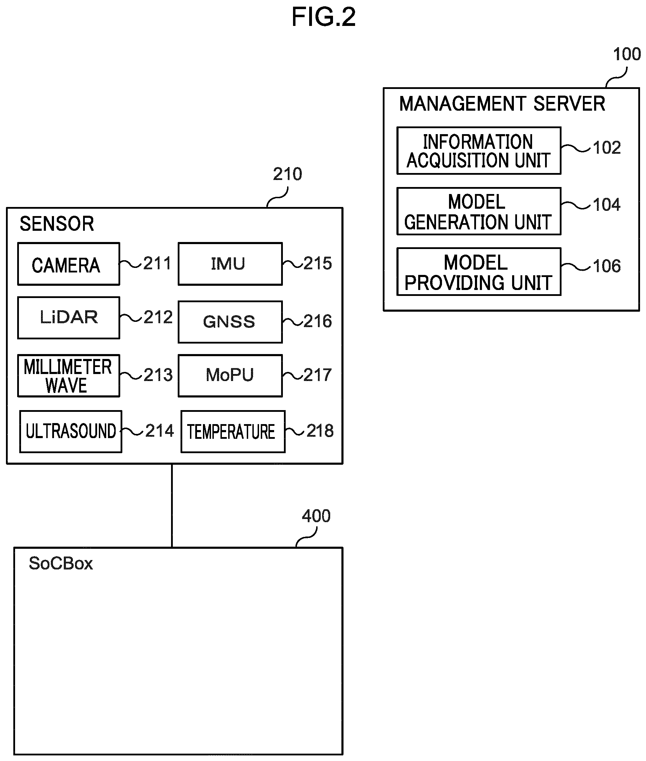

Fig. 2 is an explanatory diagram for describing a learning phase in the system 1. Here, a camera 211, a light detection and ranging (LiDAR) 212, a millimeter wave sensor 213, an ultrasonic sensor 214, an IMU sensor 215, a global navigation satellite system (GNSS) sensor 216, the MoPU 217, and a temperature sensor 218 are shown as sensors 210 mounted on the vehicle 200. The vehicle 200 need not include all of these sensors, but may include some of these sensors.

The SoCBox 400 acquires sensor information from each sensor included in the sensor 210. Furthermore, the SoCBox 400 may perform communication via the network 20, and the SoCBox 400 receives the external information from each of the plurality of servers 31 via the network 20. Then, the SoCBox 400 performs autonomous driving control of the vehicle 200 using the acquired information.

The SoCBox 400 records computing power as the operation of the SoCBox 400. The SoCBox 400 may periodically or irregularly record the computing power of the SoCBox 400. The SoCBox 400 may record the sensor information received from the sensor 210, the external information received from the server 31, and the computing power of the SoCBox 400 at the time of acquiring these pieces of information and performing the autonomous driving control, and transmit the information to the management server 101.

The management server 101 includes an information acquisition unit 102, a model generation unit 104, and a model providing unit 106. The information acquisition unit 102 acquires various types of information. The management server 101 may receive the information transmitted by the SoCBox 400.

The model generation unit 104 performs machine learning using the information acquired by the information acquisition unit 102 to generate the learning model.

The model generation unit 104 may perform machine learning using, as the learning data, the information acquired by the SoCBox 400 and the operation status of the SoCBox 400 when the SoCBox 400 acquires the information, thereby generating the learning model that receives the information acquired by the SoCBox 400 and outputs the operation status of the SoCBox 400. Specifically, the model generation unit 104 inputs the detection result of the MoPU 217 as the information acquired by the SoCBox 400, and generates the learning model that outputs a status of the power computing power and a change amount as the operation status of the SoCBox 400.

The model providing unit 106 provides the learning model generated by the model generation unit 104. The model providing unit 106 may transmit the learning model to the cooling execution device 500 mounted on the vehicle 300.

The system 1 may be configured to predict a temperature change of each of a plurality of portions of the SoCBox 400. In this case, the vehicle 200 may include a plurality of temperature sensors 218 each of which measures the temperature change of each of the plurality of portions of the SoCBox 400. The SoCBox 400 may transmit the sensor information received from the sensor 210, the external information received from the server 31, and the temperature changes measured by the plurality of temperature sensors 218 at the time of acquiring these pieces of information and performing the autonomous driving control to the management server 101. The model generation unit 104 performs machine learning using, as the learning data, the information acquired by the SoCBox 400, the temperature change of each of the plurality of portions of the SoCBox 400 when the SoCBox 400 acquires the information, and the operation status of the SoCBox 400, thereby generating the learning model that receives the information acquired by the SoCBox 400 and outputs the temperature change of each of the plurality of portions in the SoCBox 400 and the operation status of the SoCBox 400.

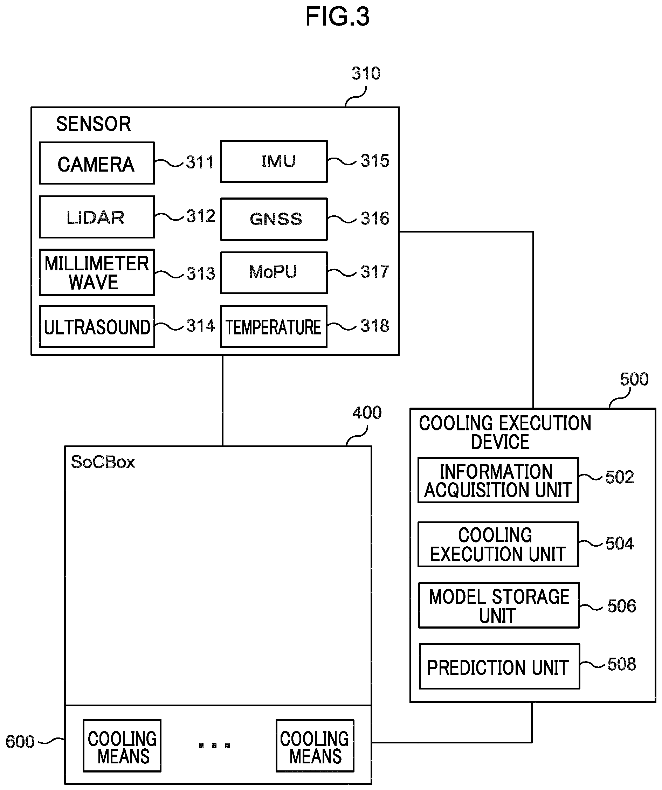

Fig. 3 is an explanatory diagram for describing a cooling execution phase in the system 1. Here, a camera 311, a LiDAR 312, a millimeter wave sensor 313, an ultrasonic sensor 314, an IMU sensor 315, a GNSS sensor 316, an MoPU 317, and a temperature sensor 318 are shown as sensors 310 mounted on the vehicle 300. The vehicle 300 need not include all of these sensors, but may include some of these sensors.

The cooling execution device 500 includes an information acquisition unit 502, a cooling execution unit 504, a model storage unit 506, and a prediction unit 508.

The information acquisition unit 502 acquires the information acquired by the SoCBox 400. The information acquisition unit 502 acquires, from the sensor 310 or the SoCBox 400, the sensor information acquired by the SoCBox 400 from the sensor 310. For example, the information acquisition unit 502 may receive, from the SoCBox 400, the sensor information acquired by the SoCBox 400 from the sensor 310. The information acquisition unit 502 may receive, from the sensor 310, the same sensor information as the sensor information acquired by the SoCBox 400 from the sensor 310. In this case, each sensor of the sensors 310 may transmit the sensor information to each of the SoCBox 400 and the cooling execution device 500.

The cooling execution unit 504 starts the cooling of the SoCBox 400 based on the detection result of the MoPU 217 included in the sensor information. For example, in a case where the detection result of the MoPU 217 indicates that the mobile object has been detected, the cooling execution unit 504 starts the cooling of the SoCBox 400.

The cooling execution unit 504 performs the cooling of the SoCBox 400 by using the cooling unit 600. The cooling unit 600 cools the SoCBox 400 by air cooling means, water cooling means, or liquid nitrogen cooling means.

In the present embodiment, a mode in which the operation of the SoCBox 400 is predicted in a case where the mobile object is detected has been described. However, the disclosure is not limited thereto. The prediction unit 508 may predict the operation of the SoCBox 400 by AI.

For example, the model storage unit 506 stores the learning model received from the management server 101. The prediction unit 508 predicts the operation status of the SoCBox 400 by inputting the detection result of the MoPU 217 acquired by the information acquisition unit 502 to the learning model stored in the model storage unit 506. Here, the learning model outputs, as the operation status, the status of the power computing power of the SoCBox 400 and the change amount. Furthermore, the prediction unit 508 may predict and output the temperature change of each of the plurality of portions in the SoCBox 400 together with the operation status.

The cooling execution unit 504 may start the cooling of the SoCBox 400 according to the operation status of the SoCBox 400 predicted by AI. For example, in a case where the status of the power computing power of the SoCBox 400 and the change amount predicted as the operation status exceed predetermined thresholds, the cooling execution unit 504 starts the cooling of the SoCBox 400. Furthermore, the cooling execution unit 504 may start the cooling of the SoCBox 400 according to the operation status of the SoCBox 400 predicted by AI and the temperature change of each portion in the SoCBox 400. For example, in a case where the status of the power computing power of the SoCBox 400 and the change amount predicted as the operation status exceed the predetermined thresholds, and the temperature change exceeds a predetermined threshold, the cooling execution unit 504 starts cooling of the corresponding portion in the SoCBox 400.

The cooling unit 600 may include a plurality of types of cooling means. For example, the cooling unit 600 includes a plurality of types of air cooling means. For example, the cooling unit 600 includes a plurality of types of water cooling means. For example, the cooling unit 600 includes a plurality of types of liquid nitrogen cooling means. The cooling unit 600 may include one or more types of air cooling means, one or more types of water cooling means, and one or more liquid nitrogen cooling means.

The plurality of cooling means may be arranged to cool different portions of the SoCBox 400, respectively. The prediction unit 508 may predict the temperature change of each of the plurality of portions of the SoCBox 400 by using the information acquired by the information acquisition unit 502. The cooling execution unit 504 may start the cooling of the SoCBox 400 by using cooling means selected from a plurality of cooling means for respectively cooling the plurality of portions of the SoCBox 400 based on a prediction result of the prediction unit 508.

The cooling execution unit 504 may perform the cooling of the SoCBox 400 by using cooling means corresponding to the temperature of the SoCBox 400 predicted by the prediction unit 508. For example, as the temperature of the SoCBox 400 is higher, the cooling execution unit 504 performs the cooling of the SoCBox 400 using a larger number of cooling means. As a specific example, the cooling execution unit 504 starts the cooling using one of the plurality of cooling means in a case where it is predicted that the temperature of the SoCBox 400 exceeds a first threshold, and increases the number of cooling means to be used in a case where it is predicted that the temperature of the SoCBox 400 increases and exceeds a second threshold.

The cooling execution unit 504 may perform the cooling of the SoCBox 400 by using stronger cooling means as the temperature of the SoCBox 400 is higher. For example, the cooling execution unit 504 starts the cooling using the air cooling means in a case where it is predicted that the temperature of the SoCBox 400 exceeds the first threshold, starts the cooling using the water cooling means in a case where it is predicted that the temperature of the SoCBox 400 still increases and exceeds the second threshold, and starts the cooling using the liquid nitrogen cooling means in a case where it is predicted that the temperature of the SoCBox 400 still increases and exceeds a third threshold.

The SoCBox 400 may include a plurality of processing chips, and the plurality of processing chips may be arranged at different positions on the SoCBox 400. The plurality of cooling means may be arranged at positions corresponding to the plurality of processing chips, respectively.

For example, in a case where the number of processing chips to be used changes according to an autonomous driving control situation, cooling using the cooling means corresponding to the used processing chip is performed, so that efficient cooling can be implemented.

In the embodiment, a mode in which the SoCBox 400 is cooled in a case where the mobile object is detected by the MoPU 217 has been described. However, the disclosure is not limited thereto. In a case where the mobile object is detected by the MoPU 217, electric power regeneration by heat generation of the SoCBox 400 may be started. For example, in a case where a Peltier element is installed in the SoCBox 400 and the mobile object is detected by the MoPU 217, power generation by the Peltier element using heat generation of the SoCBox 400 may be started. As the Peltier element is used, electric power can be immediately obtained at the time of heat generation in the SoCBox 400, so that energy efficiency is improved.

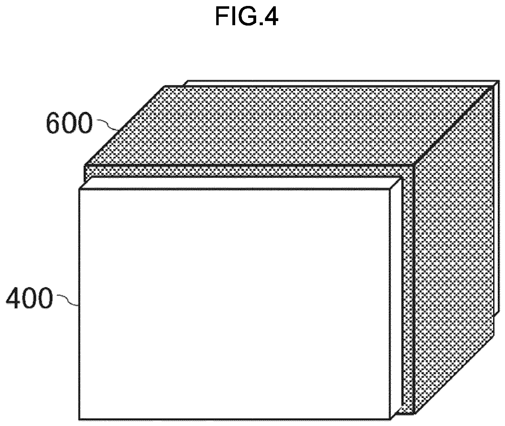

Fig. 4 schematically shows an example of the SoCBox 400 and the cooling unit 600. Fig. 4 shows a case where the cooling unit 600 includes one cooling means. In a case where the cooling execution device 500 detects the mobile object, the entire SoCBox 400 can be cooled by starting cooling by the cooling unit 600.

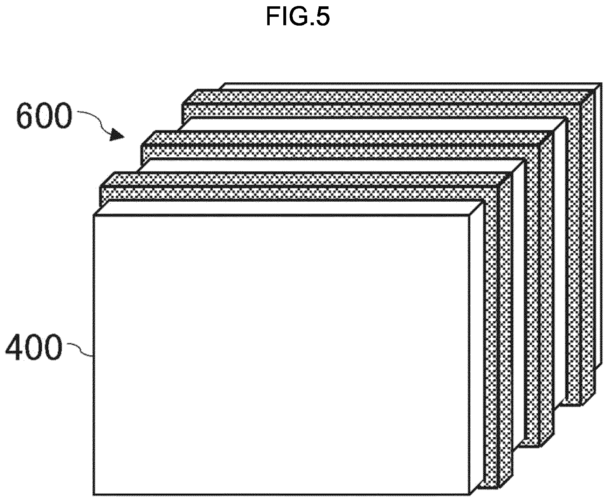

Fig. 5 schematically shows an example of the SoCBox 400 and the cooling unit 600. Fig. 5 shows a case where the cooling unit 600 includes a plurality of cooling means that cool the plurality of portions of the SoCBox 400, respectively. The cooling execution device 500 predicts the temperature change of each of the plurality of portions of the SoCBox 400 by using the temperature sensor 318, and performs the cooling using only cooling means corresponding to a corresponding portion in response to predicting that any one of the portions starts to generate heat or the temperature of any one of the portions exceeds a predetermined threshold, whereby efficient cooling can be implemented.

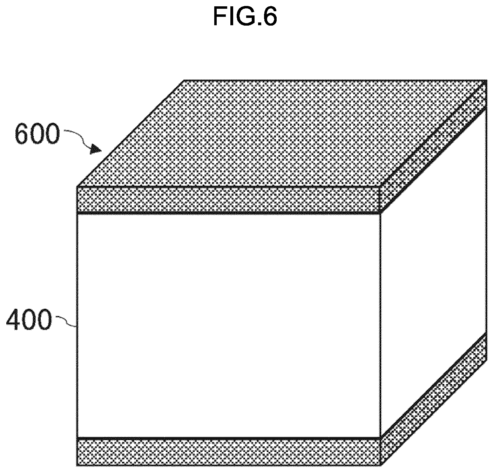

Fig. 6 schematically shows an example of the SoCBox 400 and the cooling unit 600. Fig. 6 shows a case where the cooling unit 600 includes two types of cooling means. The cooling execution device 500 predicts the temperature change of each of the plurality of portions of the SoCBox 400, and performs the cooling using only cooling means corresponding to a corresponding portion in response to predicting that any one of the portions starts to generate heat or the temperature of any one of the portions exceeds a predetermined threshold, whereby efficient cooling can be implemented. Furthermore, as the temperature of the SoCBox 400 increases, the cooling execution device 500 increases the number of cooling means to be used. That is, in this example, the cooling execution device 500 first starts cooling using one of the two types of cooling means, and then starts cooling by further using the other cooling means in a case where the temperature of the SoCBox 400 increases, whereby energy efficiency for cooling can be improved.

[Modification]

A modification of the vehicle 300 according to the above embodiment will be described below.

In a case where the detection result of the MoPU 217 indicates that the mobile object has been detected, the cooling execution unit 504 performs the cooling of the SoCBox 400 by using the cooling unit 600 and decelerate the vehicle 300. As described below, the cooling execution device 500, the cooling unit 600, and the like are driven using regenerative power (regenerative energy) generated when the vehicle 300 decelerates.

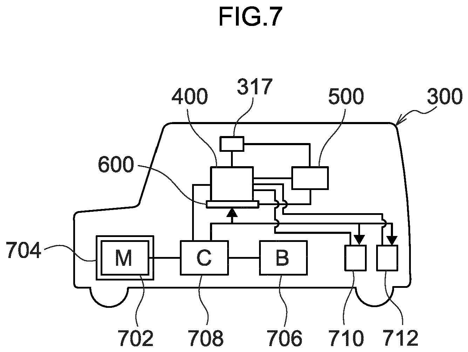

As shown in Fig. 7, the vehicle 300 according to the embodiment includes a traveling power unit 704 including a motor 702, a battery 706 that sends power to the motor 702, and a power control unit 708. The power unit 704 may include only the motor 702 or may include both the motor 702 and an internal combustion engine (engine).

The motor 702 can generate a driving force necessary for the traveling of the vehicle 300, and can function as a generator to generate the regenerative power at the time of deceleration of the vehicle 300.

The power control unit 708 can adjust the power sent from the battery 706 to the motor 702, and can send the regenerative power to the cooling execution device 500 and the cooling unit 600 at the time of vehicle deceleration. Furthermore, the power control unit 708 can adjust a regenerative power amount of the regenerative power generated by the motor 702 based on an instruction from the SoCBox 400 to adjust a deceleration of the vehicle 300. In other words, the regenerative power amount can be adjusted by adjusting the deceleration of the vehicle 300.

In the embodiment, the regenerative power is generated at the time of vehicle deceleration (in a case where the deceleration indicates that a mobile object has been detected), and the regenerative power can be supplied to the cooling execution device 500 and the cooling unit 600, so that power consumption of the battery 706 can be reduced. Furthermore, all the power used by the cooling execution device 500 and the cooling unit 600 can be covered by the regenerative power by adjusting the deceleration, and at least the cooling execution device 500 and the cooling unit 600 can be prevented from using the power of the battery 706 at the time of deceleration.

In a case where surplus regenerative power is generated, the power control unit 708 can also supply the regenerative power to power consuming equipment (a brake actuator 710, a steering actuator 712, or the like described below) other than the cooling execution device 500 and the cooling unit 600. In a case where surplus regenerative power is generated, the power control unit 708 can charge the battery 706 using the surplus regenerative power.

As shown in Fig. 7, the vehicle 300 includes the brake actuator 710 that performs a brake operation at the time of deceleration and the steering actuator 712 that performs a steering operation of the vehicle 300 based on the detection result of the MoPU 317, and power used by the brake actuator 710 and power used by the steering actuator 712 at the time of deceleration can be covered by the regenerative power.

For example, in a case where a mobile object present on a roadway is detected when the vehicle 300 is performing the autonomous driving, the steering actuator 712 can operate a steering (not shown) of the vehicle 300 such that the vehicle 300 avoids the object.

In addition, even in a case where an object approaching the vehicle 300 is detected, but an avoidance action is not in time, the vehicle 300 collides with the object, and the power from the battery 706 is lost, it is possible to safely stop the vehicle by operating the brake actuator 710 with the regenerative power.

Furthermore, until the brake operation is performed and the vehicle 300 stops, the SoCBox 400 can control the deceleration of the vehicle 300 by the brake actuator 710 such that the power used in at least a control system such as the SoCBox 400 (an example of a control device), the cooling execution device 500, the cooling unit 600, the power control unit 708, or the brake actuator 710, a cooling system, a brake system, and the like can be covered only by the regenerative power. For example, at the time of deceleration, in a case where the regenerative power at that time is insufficient for the power used in the control system, the cooling system, and the brake system, in other words, a system operating at the time of deceleration, the SoCBox 400 increases the deceleration to increase the regenerative power amount.

The power control unit 708 can be operated to cool the SoCBox 400 by using the power of the battery 706 until the regeneration is performed, and to cool the SoCBox 400 by using the regenerative power when the regeneration is performed.

Furthermore, the SoCBox 400 can control the power control unit 708 to switch a supply destination of the regenerative power according to the remaining level of the battery 706. However, in this case, the cooling of the SoCBox 400 is prioritized. In a case where the remaining level of the battery 706 is sufficient, the power of the battery 706 can also be used for cooling or the like.

(Second Embodiment)

Next, a second embodiment according to the present embodiment will be described. As an example, at least a part of the information processing device according to the disclosure is mounted on a vehicle 100 and performs autonomous driving control of the vehicle 100. Furthermore, the information processing device can provide a traveling system that can implement autonomous driving at Level 6 in real time based on data obtained by various sensor inputs in artificial intelligence (AI)/multivariate analysis/goal seek/strategy planning/optimal probabilistic solution/optimal speed solution/optimal course management/edge and is adjusted based on a delta optimal solution. The vehicle 100 is an example of a "target".

Here, "Level 6" is a level representing the autonomous driving and corresponds to a level higher than Level 5 representing fully autonomous driving. Level 5 represents the fully autonomous driving, but Level 5 is equivalent to a level of human driving, and there is still a probability that an accident or the like occurs. Level 6 represents a level higher than Level 5, and corresponds to a level at which a probability that an accident occurs is lower than that of Level 5.

Computational power at Level 6 is about 1000 times the computational power at Level 5. Therefore, Level 6 can implement high-performance driving control that cannot be implemented at Level 5.

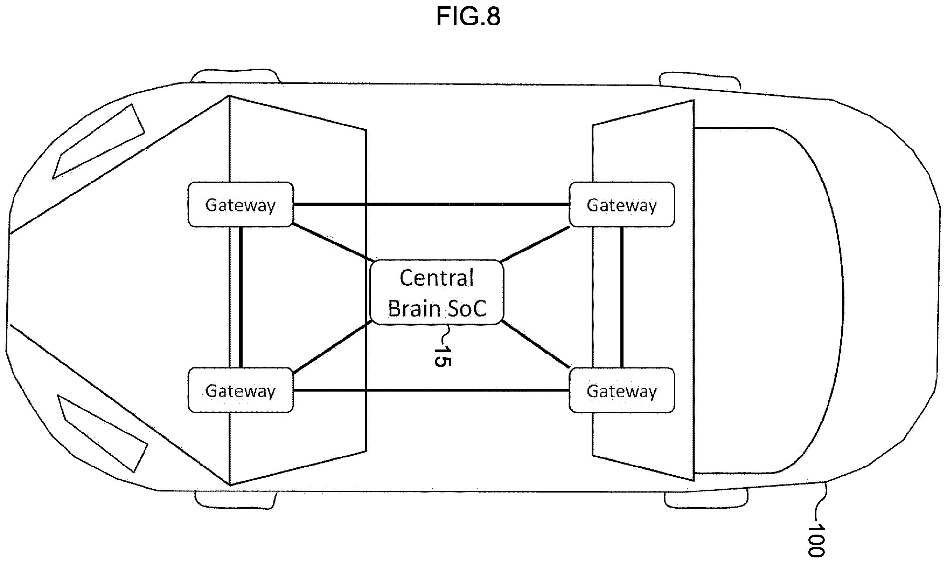

Fig. 8 is a schematic diagram showing an example of the vehicle 100 on which the central brain 15 is mounted. A plurality of gateways are communicably connected to the central brain 15. The central brain 15 is connected to an external cloud server via the gateway. The central brain 15 is configured to be able to access the external cloud server via the gateway. On the other hand, the central brain 15 cannot be directly accessed from the outside due to the presence of the gateway.

The central brain 15 outputs a request signal to the cloud server every time a predetermined time elapses. Specifically, the central brain 15 outputs a request signal indicating an inquiry to the cloud server every 1/1 billion seconds. As an example, the central brain 15 controls the autonomous driving of Level L6 based on a plurality of pieces of information acquired via the gateway.

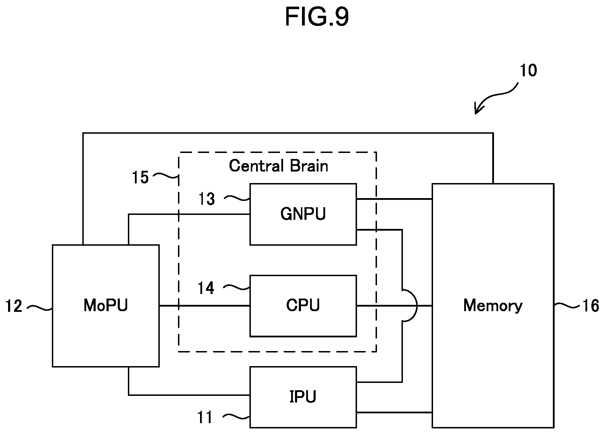

Fig. 9 is a first block diagram showing an example of a configuration of an information processing device 10. The information processing device 10 includes an image processing unit (IPU) 11, a motion processing unit (MoPU) 12, the central brain 15, and a memory 16. The central brain 15 includes a graphics neural network processing unit (GNPU) 13 and a central processing unit (CPU) 14.

The IPU 11 is built in an ultra-high-resolution camera (not shown) installed in the vehicle 100. The IPU 11 executes predetermined image processing such as Bayer conversion, demosaicing, noise removal, and sharpening on an image of an object present around the vehicle 100 captured by the ultra-high-resolution camera, and outputs the processed image of the object at a frame rate of 10 frames/second and a resolution of 12 million pixels, for example. In addition, the IPU 11 outputs identification information obtained by identifying the imaged object in the image of the object captured by the ultra-high-resolution camera. The identification information is information necessary for identifying what the imaged object is (for example, whether the object is a person or an obstacle). In the embodiment, the IPU 11 outputs, as the identification information, label information (for example, information indicating whether the imaged object is a dog, a cat, or a bear) indicating the type of the imaged object. Furthermore, the IPU 11 outputs position information indicating a position of the imaged object in a camera coordinate system of the ultra-high-resolution camera. The image, the label information, and the position information output from the IPU 11 are supplied to the central brain 15 and the memory 16. The IPU 11 is an example of a "second processor", and the ultra-high-resolution camera is an example of a "second camera".

The MoPU 12 is built in another camera (not shown) different from the ultra-high-resolution camera installed in the vehicle 100. The MoPU 12 outputs point information that represents the imaged object as a point in an image of the object captured at a frame rate of 100 frames/second or higher by the another camera oriented in a direction corresponding to that of the ultra-high-resolution camera, for example, at a frame rate of 100 frames/second or higher. The point information output from the MoPU 12 is supplied to the central brain 15 and the memory 16. As described above, the image used by the MoPU 12 to output the point information and the image used by the IPU 11 to output the identification information are images captured by the another camera and the ultra-high-resolution camera oriented in the corresponding direction. Here, the "corresponding direction" is a direction in which an imaging range of the another camera and an imaging range of the ultra-high-resolution camera overlap each other. In the above case, the another camera captures the object while being oriented in a direction overlapping the imaging range of the ultra-high-resolution camera. For example, the ultra-high-resolution camera and the another camera imaging the object while being oriented in the corresponding direction are implemented by obtaining a correspondence between the camera coordinate systems of the ultra-high-resolution camera and the another camera in advance.

For example, the MoPU 12 outputs, as the point information, coordinate values of a point indicating an existence position of the object on at least two coordinate axes in a three-dimensional orthogonal coordinate system. The coordinate values indicate a center point (or a center-of-gravity point) of the object as an example. The MoPU 12 outputs, as the coordinate values on the two coordinate axes, a coordinate value (hereinafter referred to as "x coordinate value") on an axis (x axis) along a width direction and a coordinate value (hereinafter referred to as "y coordinate value") on an axis (y axis) along a height direction in the three-dimensional orthogonal coordinate system. The x axis is an axis along a vehicle width direction of the vehicle 100, and the y axis is an axis along the height direction of the vehicle 100.

With the above configuration, the point information for 1 second output from the MoPU 12 includes the x coordinate values and the y coordinate values of 100 frames or more, so that it is possible to grasp a motion (a movement direction and a movement speed) of the object on the x axis and the y axis in the three-dimensional orthogonal coordinate system based on the point information. That is, the point information output from the MoPU 12 includes the position information indicating the position of the object in the three-dimensional orthogonal coordinate system and motion information indicating the motion of the object.

As described above, the point information output from the MoPU 12 does not include information necessary for identifying what the imaged object is (for example, whether the image object is a person or an obstacle), and includes only information indicating a motion (the movement direction and the movement speed) of the center point (or the center-of-gravity point) of the object on the x axis and the y axis. Since the point information output from the MoPU 12 does not include image information, the amount of data output to the central brain 15 and the memory 16 can be dramatically reduced. The MoPU 12 is an example of a "first processor", and the another camera is an example of a "first camera".

As described above, in the embodiment, the frame rate of the another camera in which the MoPU 12 is built is higher than the frame rate of the ultra-high-resolution camera in which the IPU 11 is built. Specifically, the frame rate of the another camera is 100 frames/second or higher, and the frame rate of the ultra-high-resolution camera is 10 frames/second. That is, the frame rate of the another camera is 10 times or more the frame rate of the ultra-high-resolution camera.

The central brain 15 associates the point information output from the MoPU 12 with the label information output from the IPU 11. For example, the central brain 15 acquires the point information for the object and does not acquire the label information in some cases due to the frame rate difference between the another camera and the ultra-high-resolution camera. In this state, the central brain 15 recognizes the x coordinate value and the y coordinate value of the object based on the point information, and does not recognize what the object is.

Thereafter, in a case where the label information for the object is acquired, the central brain 15 derives the type (for example, PERSON) of the label information. Then, the central brain 15 associates the label information with the point information acquired above. As a result, the central brain 15 recognizes the x coordinate value and the y coordinate value of the object based on the point information, and recognizes what the object is. The central brain 15 is an example of a "third processor".

Here, in a case where there are a plurality of objects such as an object A and an object B imaged by the ultra-high-resolution camera and the another camera, the central brain 15 associates the point information and the label information with each other for each object as follows. The central brain 15 acquires pieces of point information (hereinafter referred to as "point information A" and "point information B") for the object A and the object B, but does not acquire the label information in some cases due to the frame rate difference between the another camera and the ultra-high-resolution camera. In this state, the central brain 15 recognizes an x coordinate value and a y coordinate value of the object A based on the point information A and recognizes an x coordinate value and a y coordinate value of the object B based on the point information B, but does not recognize what the objects are.

Thereafter, in a case where one piece of label information is acquired, the central brain 15 derives the type (for example, PERSON) of the one piece of label information. Then, the central brain 15 specifies the point information to be associated with the one piece of label information based on the position information output from the IPU 11 together with the one piece of label information and position information included in the acquired point information A and point information B. For example, the central brain 15 specifies point information including position information indicating a position closest to the position of the object indicated by the position information output from the IPU 11, and associates the point information with the one piece of label information. In a case where the point information specified above is the point information A, the central brain 15 associates the one piece of label information with the point information A, recognizes the x coordinate value and the y coordinate value of the object A based on the point information A, and recognizes what the object A is.

As described above, in a case where there are a plurality of objects imaged by the ultra-high-resolution camera and the another camera, the central brain 15 associates the point information and the label information with each other based on the position information output from the IPU 11 and the position information included in the point information output from the MoPU 12.

In addition, the central brain 15 recognizes the object (a person, an animal, a road, a signal, a sign, a pedestrian crossing, an obstacle, a building, or the like) present around the vehicle 100 based on the image and the label information output from the IPU 11. Furthermore, the central brain 15 recognizes the position and the motion of the recognized object present around the vehicle 100 based on the point information output from the MoPU 12. The central brain 15 performs, for example, control (speed control) of a motor for driving wheels, brake control, and steering wheel control based on the recognized information, and controls autonomous driving of the vehicle 100. For example, the central brain 15 controls the autonomous driving of the vehicle 100 so as to avoid a collision with the object based on the position information and the motion information included in the point information output from the MoPU 12. In the central brain 15, the GNPU 13 may execute processing related to image recognition, and the CPU 14 may execute processing related to the vehicle control.

In general, the ultra-high-resolution camera is used to perform image recognition in autonomous driving. It is possible to recognize what an object included in an image is from the image captured by the ultra-high-resolution camera. However, it is not sufficient for the autonomous driving of Level 6. For Level 6, it is also necessary to recognize a motion of an object with higher accuracy. As the MoPU 12 recognizes the motion of the object with higher accuracy, for example, an avoidance operation in which the vehicle 100 traveling by the autonomous driving avoids an obstacle can be performed with higher accuracy. However, the ultra-high-resolution camera can acquire only about 10 frames per second, and accuracy in analyzing the motion of the object is lower than that of the camera on which the MoPU 12 is mounted. On the other hand, the camera on which the MoPU 12 is mounted can perform outputting at a high frame rate of 100 frames/second, for example.

Therefore, the information processing device 10 according to the second embodiment includes two independent processors of the IPU 11 and the MoPU 12. The information processing device 10 imparts a role of acquiring information necessary for identifying the imaged object to the IPU 11 built in the ultra-high-resolution camera, and imparts a role of detecting the position and the motion of the object to the MoPU 12 built in the another camera. The MoPU 12 represents the imaged object as a point, and analyzes in which direction on at least the x axis and the y axis in the three-dimensional orthogonal coordinate system and at what speed the coordinates of the point move. Since detection of the entire contour of the object and what the object is can be performed using the image acquired from the ultra-high-resolution camera, the MoPU 12 can grasp behavior of the entire object as long as the MoPU 12 knows how the center point of the object moves, for example.

According to a method of analyzing only the movement and the speed of the center point of the object, it is possible to greatly reduce the amount of data output to the central brain 15 and greatly reduce the amount of computation in the central brain 15 as compared with the case of determining how the entire image of the object moves. For example, in the case of outputting an image of 1000 pixels × 1000 pixels to the central brain 15 at a frame rate of 1000 frames/second, when color information is included, data of 4 billion bits/second is output to the central brain 15. Since the MoPU 12 outputs only the point information indicating the motion of the center point of the object, the amount of data output to the central brain 15 can be compressed to 20000 bits/second. That is, the amount of data output to the central brain 15 is compressed to 1/200000.

It is possible to implement object recognition including the motion of the object with a small amount of data by using the low-frame-rate and high-resolution image and the label information output from the IPU 11 and the high-frame-rate and lightweight point information output from the MoPU 12 in combination as described above.

Furthermore, in the information processing device 10, the central brain 15 associates the point information output from the MoPU 12 with the label information output from the IPU 11, so that it is possible to grasp information regarding what type of object is making what type of motion.

(Third Embodiment)

Next, a second embodiment according to the present embodiment will be described while omitting or simplifying an overlapping portion with the above embodiment.

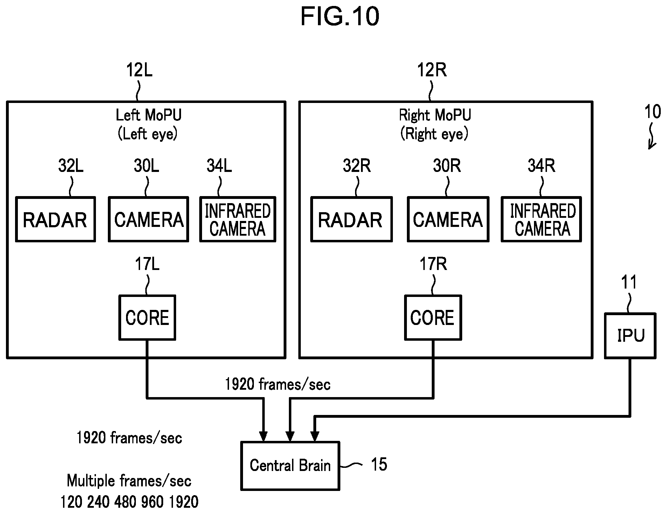

Fig. 10 is a second block diagram showing an example of a configuration of an information processing device 10. As shown in Fig. 10, an information processing device 10 mounted on a vehicle 100 includes an MoPU 12L corresponding to a left eye, an MoPU 12R corresponding to a right eye, an IPU 11, and a central brain 15.

The MoPU 12L includes a camera 30L, a radar 32L, an infrared camera 34L, and a core 17L. The MoPU 12R includes a camera 30R, a radar 32R, an infrared camera 34R, and a core 17R. Hereinafter, the MoPU 12L and the MoPU 12R are referred to as "MoPU 12" when not distinguished, the camera 30L and the camera 30R are referred to as "camera 30" when not distinguished, the radar 32L and the radar 32R are referred to as "radar 32" when not distinguished, the infrared camera 34L and the infrared camera 34R are referred to as "infrared camera 34" when not distinguished, and the core 17L and the core 17R are referred to as "core 17" when not distinguished.

The camera 30 included in the MoPU 12 images an object with a larger number of frames (120, 240, 480, 960 or 1920 frames/sec) than that of an ultra-high-resolution camera (for example, 10 frames/sec) included in the IPU 11. A frame rate of the camera 30 is variable. The camera 30 is an example of a "first camera".

The radar 32 included in the MoPU 12 acquires a radar signal which is a signal based on a reflected wave of an electromagnetic wave applied to the object from the object. The infrared camera 34 included in the MoPU 12 is a camera that captures an infrared image.

The core 17 (implemented by one or more CPUs, for example) included in the MoPU 12 extracts a feature point for each image of one frame captured by the camera 30, and outputs, as point information, an x coordinate value and a y coordinate value of the object in the above-described three-dimensional orthogonal coordinate system. For example, the core 17 uses, as the feature point, a center point (center-of-gravity point) of the object extracted from the image. The point information output by the core 17 includes position information and motion information as in the above embodiment.

The IPU 11 includes the ultra-high-resolution camera (not shown), and outputs an image of the object captured by the ultra-high-resolution camera, label information indicating the type of the object, and position information indicating a position of the object in a camera coordinate system of the ultra-high-resolution camera.

The central brain 15 acquires the point information output from the MoPU 12, and the image, the label information, and the position information output from the IPU 11. Then, the central brain 15 associates the label information for the object present at a position corresponding to the position information included in the point information output from the MoPU 12 and the position information output from the IPU 11 with the point information. As a result, the information processing device 10 can associate information indicating what the object indicated by the label information is with the position and a motion of the object indicated by the point information.

Here, the MoPU 12 changes the frame rate of the camera 30 according to a predetermined factor. In the embodiment, the MoPU 12 changes the frame rate of the camera 30 according to a score for an external environment as an example of the predetermined factor. In this case, the MoPU 12 calculates the score for the external environment for the vehicle 100, and changes the frame rate of the camera 30 according to the calculated score. Then, the MoPU 12 outputs a control signal for capturing the image at the changed frame rate to the camera 30. As a result, the camera 30 captures an image at the frame rate indicated by the control signal. With such a configuration, in the information processing device 10, the image of the object can be captured at a frame rate suitable for the external environment.

The information processing device 10 mounted on the vehicle 100 includes a plurality of types of sensors (not shown). The MoPU 12 calculates a risk level for movement of the vehicle 100 as the score for the external environment for the vehicle 100 based on sensor information (such as center of gravity shift in a weight, detection of road material, detection of outside-air temperature, detection of outside-air humidity, detection of vertical and lateral inclination angles of slopes, detection of a freezing state and a moisture level of a road, detection of a material, a wear condition, and a tire pressure of each tire, a road width, the presence or absence of no-passing zones, vehicle type information of an oncoming vehicle and preceding and following vehicles, cruising states of such vehicles, or a surrounding situation (birds, animals, soccer balls, accident vehicles, earthquakes, housework, winds, typhoons, heavy rain, light rain, snowstorm, fog, or the like)) taken in from the plurality of types of sensors and the point information. The risk level indicates the degree of risk of a place where the vehicle 100 is to travel in the future. In this case, the MoPU 12 changes the frame rate of the camera 30 according to the calculated risk level. The vehicle 100 is an example of a "movable body". With such a configuration, in the information processing device 10, the frame rate of the camera 30 can be changed according to the risk level for the movement of the vehicle 100. The sensor is an example of a "detection unit", and the sensor information is an example of "detection information".

For example, the MoPU 12 increases the frame rate of the camera 30 as the calculated risk level is higher. In a case where the calculated risk level is lower than a first threshold, the MoPU 12 changes the frame rate of the camera 30 to 120 frames/second. In a case where the calculated risk level is equal to or higher than the first threshold and lower than a second threshold, the MoPU 12 changes the frame rate of the camera 30 to any one of 240, 480, and 960 frames/second. In a case where the calculated risk level is equal to or higher than the second threshold, the MoPU 12 changes the frame rate of the camera 30 to 1920 frames/second. In a case where the risk level is any of the above, the MoPU 12 may cause the camera 30 to capture the image at the selected frame rate, and may also output a control signal to the radar 32 and the infrared camera 34 to acquire the radar signal and capture the infrared image with a numerical value corresponding to the frame rate.

For example, the MoPU 12 decreases the frame rate of the camera 30 as the calculated risk level is lower. In a case where the calculated risk level is equal to or higher than the first threshold and lower than the second threshold in a state in which the frame rate of the camera 30 is set to 1920 frames/second, the MoPU 12 changes the frame rate of the camera 30 to any one of 240, 480, and 960 frames/second. In a case where the calculated risk level is lower than the first threshold in a state in which the frame rate of the camera 30 is set to 120 frames/second, the MoPU 12 changes the frame rate of the camera 30 to 1920 frames/second. In a case where the calculated risk level is lower than the first threshold in a state in which the frame rate of the camera 30 is set to any one of 240, 480, and 960 frames/second, the MoPU 12 changes the frame rate of the camera 30 to 120 frames/second. In this case, similarly to the above, the MoPU 12 outputs the control signal to the radar 32 and the infrared camera 34 to acquire the radar signal and capture the infrared image with the numerical value corresponding to the changed frame rate of the camera 30.

Furthermore, the MoPU 12 may calculate the risk level by using big data regarding traveling already known before the vehicle 100 travels, such as long-tail incident artificial intelligence (AI) data (for example, trip data of the vehicle in which an autonomous driving control scheme of Level 5 is implemented) or map information, as information for predicting the risk level.

In the above description, the risk level is calculated as the score for the external environment, but an index serving as the score for the external environment is not limited to the risk level. For example, the MoPU 12 may calculate the score for the external environment other than the risk level based on a movement direction, a speed, or the like of the object caught on the camera 30, and change the frame rate of the camera 30 according to the score. Hereinafter, a case where the MoPU 12 calculates a speed score which is a score related to the speed of the object caught on the camera 30 and changes the frame rate of the camera 30 according to the speed score will be described. As an example, the speed score is set to be higher as the speed of the object is higher and is set to be lower as the speed of the object is lower. Then, the MoPU 12 increases the frame rate of the camera 30 as the calculated speed score is higher, and decreases the frame rate of the camera 30 as the calculated speed score is lower. Therefore, in a case where the calculated speed score is equal to or higher than a threshold due to a high speed of the object, the MoPU 12 changes the frame rate of the camera 30 to 1920 frames/second. In a case where the calculated speed score is lower than the threshold due to a low speed of the object, the MoPU 12 changes the frame rate of the camera 30 to 120 frames/second. In this case, similarly to the above, the MoPU 12 outputs the control signal to the radar 32 and the infrared camera 34 to acquire the radar signal and capture the infrared image with the numerical value corresponding to the changed frame rate of the camera 30.

Next, a case where the MoPU 12 calculates a direction score which is a score related to the movement direction of the object caught on the camera 30 and changes the frame rate of the camera 30 according to the direction score will be described. As an example, the direction score is set to be higher in a case where the movement direction of the object is a direction approaching the road, and is set to be lower in a case where the movement direction is a direction away from the road. Then, the MoPU 12 increases the frame rate of the camera 30 as the calculated direction score is higher, and decreases the frame rate of the camera 30 as the calculated direction score is lower. Specifically, the MoPU 12 specifies the movement direction of the object by using AI or the like, and calculates the direction score based on the specified movement direction. Then, in a case where the calculated direction score is equal to or higher than a threshold because the movement direction of the object is the direction approaching the road, the MoPU 12 changes the frame rate of the camera 30 to 1920 frames/second. In a case where the calculated direction score is lower than the threshold because the movement direction of the object is the direction away from the road, the MoPU 12 changes the frame rate of the camera 30 to 120 frames/second. In this case, similarly to the above, the MoPU 12 outputs the control signal to the radar 32 and the infrared camera 34 to acquire the radar signal and capture the infrared image with the numerical value corresponding to the changed frame rate of the camera 30.

Furthermore, the MoPU 12 may output the point information only for an object for which the calculated score for the external environment is equal to or higher than a predetermined threshold. In this case, for example, the MoPU 12 may determine whether or not to output the point information for the object according to the movement direction of the object caught on the camera 30. For example, the MoPU 12 need not output the point information for an object having a low influence on the traveling of the vehicle 100. Specifically, the MoPU 12 calculates the movement direction of the object caught on the camera 30, and does not output the point information for an object such as a pedestrian moving away from the road. On the other hand, the MoPU 12 outputs the point information for an object approaching the road (for example, an object such as a pedestrian who is likely to jump out onto the road). With such a configuration, in the information processing device 10, it is not necessary to output the point information for an object having a low influence on the traveling of the vehicle 100.

Furthermore, in the above description, a case where the MoPU 12 calculates the risk level has been exemplified, but the technology of the disclosure is not limited to this aspect. For example, the central brain 15 may calculate the risk level instead of the MoPU 12. In this case, the central brain 15 calculates the risk level for the movement of the vehicle 100 as the score for the external environment for the vehicle 100 based on the sensor information taken in from the plurality of types of sensors and the point information output from the MoPU 12. Then, the central brain 15 outputs, to the MoPU 12, an instruction to change the frame rate of the camera 30 according to the calculated risk level.

Furthermore, in the above description, a case where the MoPU 12 outputs the point information based on the image captured by the camera 30 has been exemplified, but the technology of the disclosure is not limited to this aspect. For example, the MoPU 12 may output the point information based on the radar signal and the infrared image instead of the image captured by the camera 30. The MoPU 12 can derive the x coordinate value and the y coordinate value of the object from the infrared image of the object captured by the infrared camera 34, similarly to the image captured by the camera 30. The radar 32 can acquire three-dimensional point cloud data of the object based on the radar signal. That is, the radar 32 can detect a coordinate on a z axis in the three-dimensional orthogonal coordinate system. Here, the z axis is an axis along a depth direction of the object and a traveling direction of the vehicle 100, and hereinafter, a coordinate value on the z axis is referred to as a "z coordinate value". In this case, the MoPU 12 derives coordinate values of the object on three coordinate axes (the x axis, the y axis, and the z axis) as the point information by combining the x coordinate value and the y coordinate value of the object imaged by the infrared camera 34 at the same timing as a timing at which the radar 32 acquires the three-dimensional point group data of the object and the z coordinate value of the object indicated by the three-dimensional point group data, by using the principle of a stereo camera. Then, the MoPU 12 outputs the derived point information to the central brain 15.

Furthermore, in the above description, a case where the MoPU 12 derives the point information has been exemplified, but the technology of the disclosure is not limited to this aspect. For example, the central brain 15 may derive the point information instead of the MoPU 12. The central brain 15 derives the point information, for example, by combining information detected by the camera 30L, the camera 30R, the radar 32, and the infrared camera 34. As a specific example, the central brain 15 performs triangulation based on an x coordinate value and a y coordinate value of the object imaged by the camera 30L and an x coordinate value and a y coordinate value of the object imaged by the camera 30R, thereby deriving the coordinate values of the object on three coordinate axes (the x axis, the y axis, and the z axis) as the point information.

Furthermore, in the above description, a case where the central brain 15 controls autonomous driving of the vehicle 100 based on the image and the label information output from the IPU 11 and the point information output from the MoPU 12 has been exemplified, but the technology of the disclosure is not limited to this aspect. For example, the central brain 15 may perform operation control of a robot based on the information output from the IPU 11 and the MoPU 12. The robot may be a humanoid smart robot that performs work instead of a human. In this case, the central brain 15 controls motions of arms, palms, fingers, feet, and the like of the robot based on the information output from the IPU 11 and the MoPU 12, and causes the robot to make motions such as gripping, grasping, holding, carrying, moving, transporting, throwing, kicking, and avoiding the object. In a case where the central brain 15 performs the operation control of the robot, the IPU 11 and the MoPU 12 may be mounted at positions corresponding to a right eye and a left eye of the robot. That is, the IPU 11 and the MoPU 12 for the right eye may be mounted on the right eye, and the IPU 11 and the MoPU 12 for the left eye may be mounted on the left eye.

(Fourth Embodiment)

Next, a third embodiment according to the present embodiment will be described while omitting or simplifying an overlapping portion with the above embodiments.

As an example, an information processing device 10 according to a fourth embodiment has a configuration shown in Fig. 9 similar to that of the second embodiment.

An MoPU 12 according to the fourth embodiment outputs, as point information, coordinate values of at least two diagonal points at vertices of a polygon surrounding a contour of an object recognized from an image captured by another camera. Similarly to the second embodiment, the coordinate values are an x coordinate value and a y coordinate value of the object in the above-described three-dimensional orthogonal coordinate system.

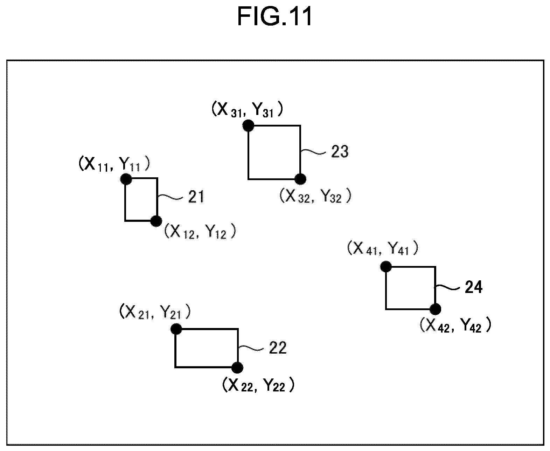

Fig. 11 is an explanatory diagram showing an example of the point information output from the MoPU 12. Fig. 11 shows bounding boxes 21, 22, 23, and 24 in which a contour of each of four objects included in the image captured by the another camera is surrounded by a quadrangle. Fig. 11 shows an aspect in which the MoPU 12 outputs, as the point information, coordinate values of two diagonal points at vertices of each of the quadrangular bounding boxes 21, 22, 23, and 24 each surrounding the contour of the object. As described above, the MoPU 12 may present the object not as a point but as an object having a certain size.

Furthermore, in the case of representing the object as the object having a certain size, the MoPU 12 may output, as the point information, coordinate values of a plurality of vertices of the polygon surrounding the contour of the object, instead of the coordinate values of two diagonal points at vertices of the polygon surrounding the contour of the object recognized from the image captured by the another camera. For example, taking Fig. 11 as an example, the MoPU 12 may output, as the point information, coordinate values of all four vertices of the bounding boxes 21, 22, 23, and 24 in which the contour of the object is surrounded by a quadrangle.

(Fifth Embodiment)

Next, a fifth embodiment according to the present embodiment will be described while omitting or simplifying an overlapping portion with the above embodiments.

As an example, an information processing device 10 according to a fifth embodiment has a configuration shown in Fig. 9 similar to that of the second embodiment.

A vehicle 100 on which the information processing device 10 according to the fifth embodiment is mounted includes a sensor including at least one of a radar, a light detection and ranging (LiDAR), a high-pixel, telephoto, ultra-wide angle, 360-degrees, high-performance camera, a vision sensor, a sound sensor, an ultrasonic sensor, a vibration sensor, an infrared sensor, an ultraviolet sensor, a radio wave sensor, a temperature sensor, and a humidity sensor. Examples of sensor information taken in from the sensor by the information processing device 10 include center of gravity shift in a weight, detection of road material, detection of outside-air temperature, detection of outside-air humidity, detection of vertical and lateral inclination angles of slopes, detection of a freezing state and a moisture level of a road, detection of a material, a wear condition, and a tire pressure of each tire, a road width, the presence or absence of no-passing zones, an oncoming vehicle, vehicle type information of preceding and following vehicles, cruising states of such vehicles, and a surrounding situation (birds, animals, soccer balls, accident vehicles, earthquakes, housework, winds, typhoons, heavy rain, light rain, snowstorm, fog, or the like). The sensor is an example of a "detection unit", and the sensor information is an example of "detection information".

A central brain 15 according to the fifth embodiment calculates a control variable for controlling autonomous driving of the vehicle 100 based on the sensor information detected by the sensor. The central brain 15 acquires the sensor information every 1/1 billion seconds. Specifically, the central brain 15 calculates control variables for controlling a wheel speed and an inclination of each of four wheels of the vehicle 100 and a suspension supporting the wheels. The inclination of the wheel includes both an inclination of the wheel with respect to an axis horizontal to the road and an inclination of the wheel with respect to an axis perpendicular to the road. In this case, the central brain 15 calculates a total of 16 control variables for controlling the wheel speed of each of the four wheels, the inclination of each of the four wheels with respect to the axis horizontal to the road, the inclination of each of the four wheels with respect to the axis perpendicular to the road, and the suspension supporting each of the four wheels.

Then, the central brain 15 controls the autonomous driving of the vehicle 100 based on the control variables calculated above, point information output from an MoPU 12, and label information output from an IPU 11. Specifically, the central brain 15 controls in-wheel motors respectively mounted on the four wheels based on 16 control variables described above, thereby controlling the wheel speed and the inclination of each of the four wheels of the vehicle 100 and the suspension supporting each of the four wheels to perform the autonomous driving. Furthermore, the central brain 15 recognizes a position and a motion of a recognized object present around the vehicle 100 based on the point information and the label information, and controls the autonomous driving of the vehicle 100 to avoid a collision with the object, for example, based on the recognized information. As the central brain 15 controls the autonomous driving of the vehicle 100 in this manner, for example, in a case where the vehicle 100 travels on a mountain road, it is possible to perform optimal steering suitable for the mountain road, and in a case where the vehicle 100 is parked in a parking lot, it is possible to perform traveling at an optimal angle suitable for the parking lot.

Here, the central brain 15 may be capable of inferring the control variable from the sensor information and information that can be acquired from a server (not shown) or the like via a network using machine learning, more specifically, deep learning. In other words, the central brain 15 can be implemented by AI.

The central brain 15 can obtain the control variable by performing multivariate analysis (see, for example, Formula (2)) by an integration method as shown in the following Formula (1) using computational power for implementing Level 6 (hereinafter also referred to as "computational power of Level 6"), the computational power being computational power for the sensor information and long-tail incident AI data of every 1/1 billion seconds. More specifically, each control variable is obtained at an edge level and in real time while obtaining an integral value of various ultra high resolution delta values with the computational power of Level 6, and a result (that is, each control variable) obtained in the next 1/1 billion seconds can be acquired as the highest probabilistic value. In order to implement such a configuration, for example, an integral value obtained by time-integrating delta values (for example, minute time change values) of a function (in other words, a function indicating behavior of each variable) capable of specifying each variable (for example, the sensor information and the information that can be acquired via the network) such as an air resistance, a road resistance, a road element (for example, garbage), or a slip coefficient is input to a deep learning model (for example, a trained model obtained by performing deep learning on a neural network) of the central brain 15. The deep learning model of the central brain 15 outputs the control variable (for example, the control variable with the highest certainty level (that is, an evaluation value)) corresponding to the input integral value. The output of the control variable is performed in units of 1/1 billion seconds.

[Math. 1]

$$ \mathrm{v} = \int_a^b f(A)\,dt \tag{1} $$

[Math. 2]

$$ V_n = DL\big(f(A,B,C,D,\cdots,N)(dA_n/dt)\big) \tag{2} $$

As an example, in Formula (1), "f(A)" is an expression in which the function indicating the behavior of each variable such as the air resistance, the road resistance, the road element (for example, garbage), or the slip coefficient is expressed in a simplified manner. Furthermore, as an example, Formula (1) is a formula indicating a time integral v of "f(A)" from time a to time b. In Formula (2), DL represents deep learning (for example, a deep learning model optimized by performing deep learning on a neural network), $dA_n/dt$ represents the delta value of $f(A,B,C,D,\cdots,N)$, A, B, C, D, ..., and N represent the variables such as the air resistance, the road resistance, the road element (for example, garbage), and the slip coefficient, $f(A,B,C,D,\cdots,N)$ represents a function representing behavior of A, B, C, D, ..., and N, and $V_n$ represents a value (control variable) output from the deep learning model optimized by performing deep learning on the neural network.

Here, a mode example in which the integral value obtained by time-integrating the delta values of the function is input to the deep learning model of the central brain 15 is described, but this is merely an example. For example, the integral value (for example, the result obtained in the next 1/1 billion seconds) obtained by time-integrating the delta values of the function indicating the behavior of each variable such as the air resistance, the road resistance, the road element, or the slip coefficient may be inferred by the deep learning model of the central brain 15, and as an inference result, an integral value with the highest certainty level (that is, the evaluation value) may be acquired by the central brain 15 every 1/1 billion seconds.

Here, a mode example in which the integral value is input to the deep learning model or the integral value is output from the deep learning model is described, but this is merely an example, and the technology of the disclosure can be established without using the integral value. For example, at least one control variable may be inferred by the deep learning model optimized by performing deep learning on the neural network using training data in which values corresponding to A, B, C, D, ..., and N are used as example data and a value corresponding to the at least one control variable (for example, the result obtained in the next 1/1 billion seconds) is used as ground truth data.

The control variable obtained by the central brain 15 can be further refined by increasing the number of times the deep learning is performed. For example, it is possible to calculate a more accurate control variable by using enormous data such as rotation of a tire or a motor, a steering angle, a material of a road, weather, a garbage, an influence of quadratic deceleration, slip, steering for of balance loss and recovery, and a speed control method, or long-tail incident AI data.

(Sixth Embodiment)

Next, a fifth embodiment according to the present embodiment will be described while omitting or simplifying an overlapping portion with the above embodiments.

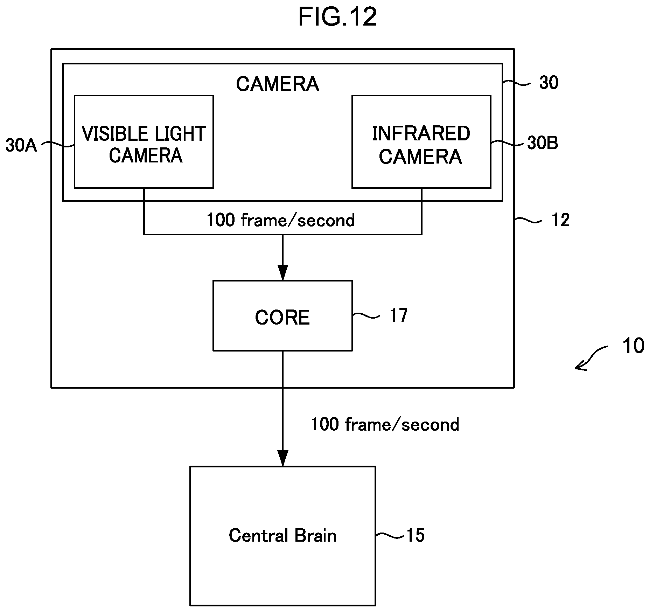

Fig. 12 is a third block diagram showing an example of a configuration of an information processing device 10. Fig. 12 shows only a configuration of a part of the information processing device 10.

As shown in Fig. 12, in an MoPU 12, a visible light image and an infrared image of an object captured by a camera 30 are input to a core 17 at a frame rate of 100 frames/second or higher. The camera 30 includes a visible light camera 30A capable of capturing the visible light image of the object and an infrared camera 30B capable of capturing the infrared image of the object. Then, the core 17 outputs point information to a central brain 15 based on at least one of the visible light image and the infrared image that are input.

Here, in a case where the object can be identified from the visible light image of the object captured by the visible light camera 30A, the core 17 outputs the point information based on the visible light image. On the other hand, in a case where the object is not identified from the visible light image due to a predetermined factor, the core 17 outputs the point information based on the infrared image of the object captured by the infrared camera 30B. For example, it is assumed that the core 17 cannot identify the object from the visible light image due to an influence of darkness as the predetermined factor. In this case, the core 17 detects heat of the object by using the infrared camera 30B, and outputs the point information of the object based on the infrared image which is the detection result. The technology of the disclosure is not limited thereto, and the core 17 may output the point information based on the visible light image and the infrared image.

Furthermore, the MoPU 12 synchronizes a timing at which the visible light image is captured by the visible light camera 30A with a timing at which the infrared image is captured by the infrared camera 30B. Specifically, the MoPU 12 outputs a control signal to the cameras 30 so as to capture the visible light image and the infrared image at the same timing. As a result, the number of images per second captured by the visible light camera 30A and the number of images per second captured by the infrared camera 30B are synchronized with each other (for example, 1920 frames/second).

(Seventh Embodiment)

Next, a seventh embodiment according to the present embodiment will be described while omitting or simplifying an overlapping portion with the above embodiments.

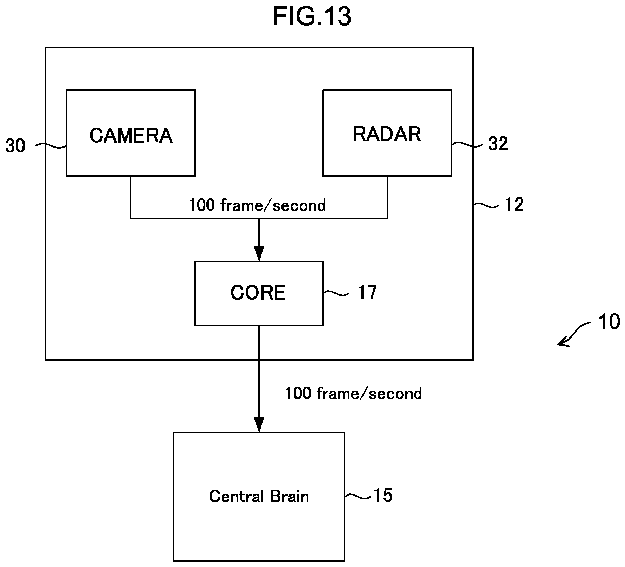

Fig. 13 is a fourth block diagram showing an example of a configuration of an information processing device 10. Fig. 13 shows only a configuration of a part of the information processing device 10.

As shown in Fig. 13, in an MoPU 12, an image of an object captured by a camera 30 and a radar signal based on a reflected wave of an electromagnetic wave emitted to the object by a radar 32 from the object are input to a core 17 at a frame rate of 100 frames/second or higher. Then, the core 17 outputs point information to a central brain 15 based on the image of the object and the radar signal that are input. The core 17 can derive an x coordinate value and a y coordinate value of the object from the input image of the object. As described above, the radar 32 can acquire three-dimensional point cloud data of the object based on the radar signal and detect a coordinate on the z axis in the above-described three-dimensional orthogonal coordinate system. In this case, the core 17 derives coordinate values of the object on three coordinate axes (the x axis, the y axis, and the z axis) as the point information by combining the x coordinate value and the y coordinate value of the object imaged by the camera 30 at the same timing as a timing at which the radar 32 acquires the three-dimensional point group data of the object and the z coordinate value of the object indicated by the three-dimensional point group data, by using the principle of a stereo camera. The image of the object input to the core 17 may include at least one of a visible light image and an infrared image.

Furthermore, the MoPU 12 synchronizes a timing at which the camera 30 captures the image with a timing at which the radar 32 acquires the three-dimensional point cloud data of the object based on the radar signal. Specifically, the MoPU 12 captures the image at the same timing and outputs a control signal to the camera 30 and the radar 32 so as to acquire the three-dimensional point cloud data of the object. As a result, the number of images per second captured by the camera 30 is synchronized with the number of pieces of three-dimensional point cloud data per second acquired by the radar 32 (for example, 1920 frames/sec). As described above, the number of images per second captured by the camera 30 and the number of pieces of three-dimensional point cloud data per second acquired by the radar 32 are larger than a frame rate of an ultra-high-resolution camera included in an IPU 11, that is, the number of images per second captured by the ultra-high-resolution camera.

(Eighth Embodiment)

Next, an eighth embodiment according to the present embodiment will be described while omitting or simplifying an overlapping portion with the above embodiments.

As an example, an information processing device 10 according to the eighth embodiment has a configuration shown in Fig. 9 similar to that of the second embodiment.

A central brain 15 according to the eighth embodiment associates, with label information, point information output from an MoPU 12 at the same timing as a timing at which an IPU 11 outputs the label information. Furthermore, in a case where new point information is output from the MoPU 12 after the point information and the label information are associated with each other, the central brain 15 also associates the new point information with the label information. The new point information is point information of the same object as an object indicated by the point information associated with the label information, and is one or more pieces of point information from when the association is performed to when the next label information is output. In the seventh embodiment, similarly to the above embodiment, a frame rate of another camera in which the MoPU 12 is built is 100 frames/second or higher (for example, 1920 frames/sec), and a frame rate of an ultra-high-resolution camera in which the IPU 11 is built is 10 frames/second.

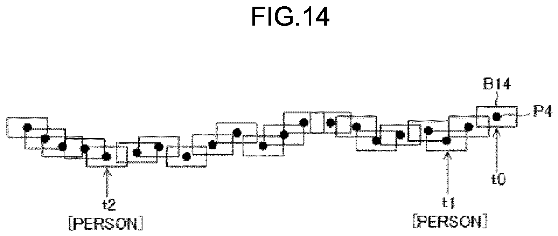

Fig. 14 is an explanatory diagram showing an example of association between the point information and the label information. In the following description, the number of pieces of point information per second output from the MoPU 12 is referred to as an "output rate of the point information", and the number of pieces of label information per second output from the IPU 11 is referred to as an "output rate of the label information".

Fig. 14 shows a time series of an output rate of point information P4 of an object B14. The output rate of the point information P4 for the object B14 is 1920 frames/second. Further, the point information P4 moves from right to left in the figure. An output rate of label information for the object B14 is 10 frames/second, which is lower than the output rate of the point information P4.

First, at time t0, the label information for the object B14 is not output from the IPU 11. Therefore, at time t0, the central brain 15 recognizes coordinate values (position information) of the object B14 based on the point information P4, and does not recognize what the object B14 is.

Next, at time t1, the label information for the object B14 is output from the IPU 11. Therefore, the central brain 15 derives label information "PERSON" for the object B14 based on the label information. Then, the central brain 15 associates the label information "PERSON" derived at time t1 with the coordinate values (position information) of the point information P4 output from the MoPU 12 at time t1. As a result, at time t1, the central brain 15 recognizes the coordinate values (position information) of the object B14 based on the point information P4 and recognizes what the object B14 is.

In Fig. 14, a timing at which the next label information for the object B14 is output from the IPU 11 is time t2. Therefore, at time t2, the central brain 15 derives the label information "PERSON" for the object B14 based on the label information output from the IPU 11. Then, the central brain 15 associates the label information "PERSON" derived at time t2 with the coordinate values (position information) of the point information P4 output from the MoPU 12 at time t2.

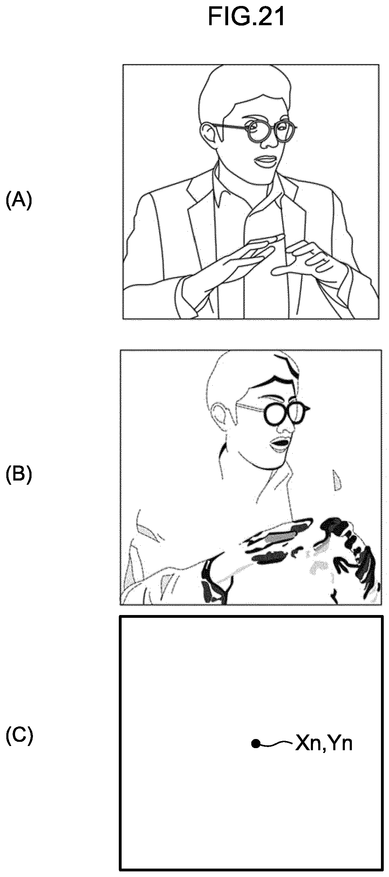

Here, the point information P4 for the object B14 is acquired by the central brain 15, and the label information is not acquired in a period from time t1 to time t2 due to the frame rate difference between the another camera in which the MoPU 12 is built and the ultra-high-resolution camera in which the IPU 11 is built. In this case, the central brain 15 associates the point information P4 acquired in the period from time t1 to time t2 with the label information "PERSON" associated with the immediately preceding time t1. Here, the point information P4 acquired by the central brain 15 in the period from time t1 to time t2 is an example of the "new point information". In the example shown in Fig. 21, a plurality of pieces of point information P4 are output from the MoPU 12 in the period from time t1 to time t2, and thus, the central brain 15 acquires the plurality of pieces of point information P4. Therefore, in the example shown in Fig. 14, the central brain 15 associates any one of the plurality of pieces of point information P4 acquired in the period from time t1 to time t2 with the label information "PERSON" associated with the immediately preceding time t1. Unlike the example shown in Fig. 14, in a case where one piece of point information P4 is output from the MoPU 12 in the period from time t1 to time t2, the central brain 15 associates the one piece of point information P4 with the label information "PERSON" associated with the immediately preceding time t1.

Here, even in a case where there is a period in which the type of the object whose motion is being tracked is uncertain, the central brain 15 continuously outputs the point information of the object at a high frame rate, and thus, a risk of losing the coordinate values (position information) of the object is low. Therefore, in a case where the association between the point information and the label information is performed once, the central brain 15 can presumptively assign the immediately preceding label information to the point information acquired before the next label information is acquired.

(Ninth Embodiment)

Next, a ninth embodiment according to the present embodiment will be described while omitting or simplifying an overlapping portion with the above embodiments.

Heat generation becomes a problem in a case where an information processing device 10 that controls autonomous driving of a vehicle 100 performs advanced arithmetic processing. Therefore, the ninth embodiment provides the vehicle 100 having a cooling function for the information processing device 10.

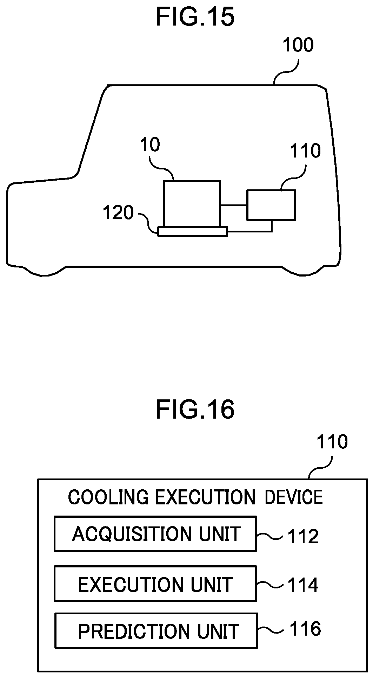

Fig. 15 is an explanatory diagram showing a schematic configuration of the vehicle 100. As shown in Fig. 15, the information processing device 10, a cooling execution device 110, and a cooling unit 120 are mounted on the vehicle 100.

The information processing device 10 according to the ninth embodiment is an device that controls the autonomous driving of the vehicle 100, and has, as an example, a configuration shown in Fig. 9 similar to that of the second embodiment. The cooling execution device 110 acquires an object detection result of the information processing device 10, and causes the cooling unit 120 to cool the information processing device 10 based on the detection result. The cooling unit 120 cools the information processing device 10 by using at least one cooling means such as air cooling means, water cooling means, and liquid nitrogen cooling means. Hereinafter, a central brain 15 (specifically, a CPU 14 included in the central brain 15) that controls the autonomous driving of the vehicle 100 is described as a cooling target in the information processing device 10, but the cooling target is not limited thereto.

The information processing device 10 and the cooling execution device 110 are communicably connected via a network (not shown). The network may be any one of a vehicle network, the Internet, a local area network (LAN), and a mobile communication network. The mobile communication network may conform to any one of a 5th generation (5G) communication scheme, a long term evolution (LTE) communication scheme, a 3rd generation (3G) communication scheme, and a subsequent communication scheme including a 6th generation (6G) communication scheme.

Fig. 16 is a block diagram showing an example of a functional configuration of the cooling execution device 110. As shown in Fig. 16, the cooling execution device 110 includes an acquisition unit 112, an execution unit 114, and a prediction unit 116 as functional configurations.

The acquisition unit 112 acquires the object detection result of the information processing device 10. For example, the acquisition unit 112 acquires point information of an object output from an MoPU 12 as the detection result.

The execution unit 114 performs the cooling of the central brain 15 based on the object detection result acquired by the acquisition unit 112. For example, in a case where movement of the object is recognized based on the point information of the object output from the MoPU 12, the execution unit 114 causes the cooling unit 120 to start cooling the central brain 15.

The execution unit 114 is not limited to performing cooling of the central brain 15 based on the object detection result, and may perform cooling of the central brain 15 based on a prediction result for an operation status of the information processing device 10.

Here, the prediction unit 116 predicts the operation status of the information processing device 10, specifically, the central brain 15, based on the object detection result acquired by the acquisition unit 112. For example, the prediction unit 116 acquires a learning model stored in a predetermined storage region. Then, the prediction unit 116 predicts the operation status of the central brain 15 by inputting the point information of the object output from the MoPU 12 acquired by the acquisition unit 112 to the learning model. Here, the learning model outputs a status and a change amount of computing power of the central brain 15 as the operation status. Furthermore, the prediction unit 116 may predict and output a temperature change of the information processing device 10, specifically, the central brain 15, together with the operation status. For example, the prediction unit 116 predicts the temperature change of the central brain 15 based on the number of pieces of point information of the object output from the MoPU 12 acquired by the acquisition unit 112. In this case, the prediction unit 116 predicts that the temperature change increases as the number of pieces of point information increases, and predicts that the temperature change decreases as the number of pieces of point information decreases.

In the above case, the execution unit 114 causes the cooling unit 120 to start cooling the central brain 15 based on the prediction result for the operation status of the central brain 15 from the prediction unit 116. For example, in a case where the status and the change amount of the computing power of the central brain 15 predicted as the operation status exceed predetermined thresholds, the execution unit 114 starts cooling by the cooling unit 120. Furthermore, in a case where a temperature based on the temperature change of the central brain 15 predicted as the operation status exceeds a predetermined threshold, the execution unit 114 starts cooling by the cooling unit 120.

Furthermore, the execution unit 114 may perform the cooling of the central brain 15 by using cooling means corresponding to the prediction result for the temperature change of the central brain 15 from the prediction unit 116. For example, the execution unit 114 may cause the cooling unit 120 to perform cooling by using a larger number of cooling means as the predicted temperature of the central brain 15 is higher. As a specific example, in a case where it is predicted that the temperature of the central brain 15 exceeds a first threshold, the execution unit 114 causes the cooling unit 120 to perform cooling using one cooling means. On the other hand, in a case where it is predicted that the temperature of the central brain 15 exceeds a second threshold higher than the first threshold, the execution unit 114 causes the cooling unit 120 to perform cooling using a plurality of cooling means.

Furthermore, the execution unit 114 may perform the cooling of the central brain 15 by using stronger cooling means as the predicted temperature of the central brain 15 is higher. For example, in a case where it is predicted that the temperature of the central brain 15 exceeds the first threshold, the execution unit 114 causes the cooling unit 120 to perform cooling using the air cooling means. Furthermore, in a case where it is predicted that the temperature of the central brain 15 exceeds the second threshold higher than the first threshold, the execution unit 114 causes the cooling unit 120 to perform cooling using the water cooling means. Furthermore, in a case where it is predicted that the temperature of the central brain 15 exceeds a third threshold higher than the second threshold, the execution unit 114 causes the cooling unit 120 to perform cooling using the liquid nitrogen cooling means.

Furthermore, the execution unit 114 may determine the cooling means to be used for cooling based on the number of pieces of point information of the object output from the MoPU 12 acquired by the acquisition unit 112. In this case, the execution unit 114 may perform the cooling of the central brain 15 by using stronger cooling means as the number of pieces of point information is larger. For example, in a case where the number of pieces of point information exceeds a first threshold, the execution unit 114 causes the cooling unit 120 to perform cooling using the air cooling means. In addition, in a case where the number of pieces of point information exceeds a second threshold larger than the first threshold, the execution unit 114 causes the cooling unit 120 to perform cooling using the water cooling means. Furthermore, in a case where the number of pieces of point information exceeds a third threshold larger than the second threshold, the execution unit 114 causes the cooling unit 120 to perform cooling using the liquid nitrogen cooling means.

In some cases, a mobile object present on a roadway may be detected as a trigger for operation of the central brain 15. For example, in a case where a mobile object present on a roadway is detected when the vehicle 100 is performing the autonomous driving, the central brain 15 may execute arithmetic processing for controlling the vehicle 100 with respect to the object. As described above, heat generation when the central brain 15 that controls the autonomous driving of the vehicle 100 executes advanced arithmetic processing becomes a problem. Therefore, the cooling execution device 110 according to the eighth embodiment predicts heat dissipation of the central brain 15 based on the object detection result of the information processing device 10, and perform the cooling of the central brain 15 before or simultaneously with the start of heat dissipation. As a result, the central brain 15 is suppressed from becoming high temperature during the autonomous driving of the vehicle 100, and an advanced arithmetic operation during the autonomous driving becomes possible.

As described above, the cooling execution device 110 according to the ninth embodiment perform cooling of the central brain 15 based on an object detection result of the information processing device 10 (MoPU 12). Then, the cooling execution device 110 stops the cooling of the central brain 15 in a case where a predetermined condition is satisfied. Specifically, the execution unit 114 of the cooling execution device 110 stops the cooling of the central brain 15 by the cooling unit 120 in a case where the predetermined condition is satisfied. By stopping the cooling of the central brain 15 in a case where the predetermined condition is satisfied in this manner, excessive cooling can be suppressed. This makes it possible to reduce power consumption of the vehicle 100.

Furthermore, the predetermined condition may include, for example, a condition that the object detected by the information processing device 10 is no longer detected, and a condition that the object detected by the information processing device 10 is moving toward the outside of a detection range. That is, the execution unit 114 may stop the cooling of the central brain 15 in a case where the condition that the object detected by the information processing device 10 is no longer detected is satisfied, or may stop the cooling of the central brain 15 in a case where the condition that the object detected by the information processing device 10 is moving toward the outside of the detection range is satisfied. A state in which the object detected by the information processing device 10 is no longer detected may include, for example, a state in which the detected object is positioned outside the detection range of the MoPU 12 (outside the detection range), that is, outside an imaging range of another camera, or a state in which the object is stationary. Furthermore, a state in which the object detected by the information processing device 10 is moving toward the outside of the detection range may include a state in which the detected object is moving (relative movement) toward the outside of the detection range of the MoPU 12, that is, toward the outside of the imaging range of another camera. As described above, in a case where the condition that the object detected by the information processing device 10 is no longer detected is satisfied or in a case where the condition that the object detected by the information processing device 10 is moving toward the outside of the detection range is satisfied, excessive cooling (in other words, unnecessary cooling) of the central brain 15 can be effectively suppressed by stopping the cooling of the central brain 15.

Furthermore, the execution unit 114 may determine to stop the cooling of the central brain 15 based on a relationship between a collimation line determined in advance in another camera in which the MoPU 12 is built and the object detected by the information processing device 10. For example, in a case where the object detected by the information processing device 10 is directed to the collimation line, the execution unit 114 may maintain the cooling of the central brain 15, and in a case where the detected object moves away from the collimation line, the execution unit 114 may stop the cooling of the central brain 15. Furthermore, in a case where there is no change in a positional relationship between the object detected by the information processing device 10 and the collimation line, the execution unit 114 may determine whether to maintain or stop the cooling of the central brain 15 in consideration of a motion of the detected object in a z axis direction (a front-rear direction of the vehicle).

Furthermore, in a case where the predetermined condition is satisfied, the execution unit 114 may stop the cooling of the central brain 15 after a predetermined time elapses. Specifically, in a case where the condition that the object detected by the information processing device 10 is no longer detected is satisfied, or in a case where the condition that the object detected by the information processing device 10 is moving toward the outside of the detection range is satisfied, the execution unit 114 may stop the cooling of the central brain 15 after the predetermined time elapses. Here, the predetermined time may be determined according to a type, a size, an acceleration, a distance, and the like of the detected object. In a case where the predetermined condition is satisfied in this manner, the cooling of the central brain 15 is stopped after the predetermined time elapses, so that the central brain 15 can be cooled even until the predetermined time elapses after the predetermined condition is satisfied.

Furthermore, the prediction unit 116 predicts the operation status of the central brain 15 by inputting the point information of the object output from the MoPU 12 acquired by the acquisition unit 112 to the learning model, and may further predict a time when the temperature of the central brain 15 becomes equal to or lower than a threshold. Learning at the time when the temperature of the central brain 15 is equal to or lower than the threshold may be performed by using data collected by the vehicle 100. For example, a cloud server connected to the central brain 15 may collect data from the vehicle 100 and perform learning. Specifically, training data with an assumed temperature of the central brain 15 as an output for input of the type, the size, the acceleration, the distance, and the like of the object detected in the MoPU 12 is prepared, and the cloud server generates a trained cooling model based on the training data. Then, in the cooling execution device 110 into which the trained cooling model has been introduced, the prediction unit 116 inputs a detection status of the central brain 15 to the cooling model and obtains a predicted temperature of the central brain 15, so that suitable cooling of the central brain 15 can be performed. Instead of outputting the predicted temperature of the central brain 15 by the cooling model, a cooling condition (for example, a cooling strength or a cooling time) for the central brain 15 may be output. In this case, the learning using the training data based on the cooling condition is performed at the time of training the cooling model. A subject that performs the learning is not limited to the cloud server, and may be another device. Here, the execution unit 114 may stop the cooling of the central brain 15 in a case where a predetermined condition that the time when the temperature of the central brain 15 predicted by the prediction unit 116 is equal to or lower than the threshold is reached is satisfied. In a case where the condition that the time predicted by the prediction unit 116 is reached is satisfied in this manner, the excessive cooling of the central brain 15 can be effectively suppressed by stopping the cooling of the central brain 15.

[Modification]

Furthermore, the cooling execution device 110 may perform the cooling of the central brain 15 based on the prediction result for the operation status of the central brain 15 from the prediction unit 116, and may adjust a cooling amount for the central brain 15 based on the prediction result for the temperature change of the central brain 15 from the prediction unit 116. The prediction result for the temperature change from the prediction unit 116 can be obtained as a temperature curve of the central brain 15 by inputting the prediction result for the operation status of the central brain 15 to a trained model for temperature prediction. The trained model for temperature prediction is a model that is machine-learned in advance by using various actual operation statuses in the central brain 15 as inputs and using an actual temperature for the operation status as an output. The "various operation statuses" in the central brain 15 include an approaching status, the number of approaching objects, an approaching speed, and the like with respect to the vehicle 100. That is, the execution unit 114 of the cooling execution device 110 increases the cooling amount by cooling means in a case where the prediction result for the temperature change of the central brain 15 from the prediction unit 116 is a temperature rise, decreases the cooling amount by the cooling means in a case where the prediction result for the temperature change is a temperature drop, and maintains the cooling amount by the cooling means in a case where the prediction result for the temperature change is no temperature change. For example, in a case where a status of power computing power of the central brain 15 predicted as the operation status and a change amount exceed predetermined thresholds, and in a case where the temperature rises, or in a case where the temperature rise exceeds a predetermined threshold, the execution unit 114 increases the cooling amount for the central brain 15. Here, the "predetermined threshold" may be set to a predetermined ratio to a peak value of a heat generation amount of the central brain 15, for example, a value of 80%. In addition, the "predetermined threshold" may vary depending on an outdoor temperature, a humidity, and the degree of traveling wind.

In addition, in a case where the execution unit 114 uses the air cooling means, the cooling amount for the central brain 15 corresponds to an air volume. In a case where the execution unit 114 uses the water cooling means or the liquid nitrogen cooling means, the cooling amount for the central brain 15 corresponds to a temperature and a circulation speed of a refrigerant.

As described above, the execution unit 114 performs the cooling of the central brain 15 based on the prediction result for the operation status of the central brain 15 from the prediction unit 116, and adjusts the cooling amount for the central brain 15 based on the prediction result for the temperature change of the central brain 15 from the prediction unit 116, whereby supercooling and insufficient cooling for the central brain 15 can be suppressed. That is, the amount of cooling by the execution unit 114 can be brought close to an appropriate amount.

Furthermore, in the cooling execution device 110, the prediction unit 116 may further predict a peak of the temperature in the central brain 15, and the execution unit 114 may perform the cooling of the central brain 15 with a cooling amount corresponding to the peak of the temperature predicted by the prediction unit 116. The cooling amount for the central brain 15 is set in advance according to the peak of the temperature. As described above, since the execution unit 114 cools the central brain 15 with the cooling amount corresponding to the peak of the temperature predicted by the prediction unit 116, it is possible to suppress supercooling and insufficient cooling of the central brain 15. That is, the amount of cooling by the execution unit 114 can be further brought close to an appropriate amount.

Furthermore, in the cooling execution device 110, the execution unit 114 may perform the cooling of the central brain 15 such that the cooling amount corresponding to the peak of the temperature is obtained before reaching the peak of the temperature predicted by the prediction unit 116. A trigger before reaching the peak of the temperature can be set in a case where the predicted temperature of the central brain 15 from the prediction unit 116 exceeds a predetermined set temperature and in a case where a predetermined time when the temperature of the central brain 15 reaches the peak is reached. In these cases, since the cooling amount for the central brain 15 becomes the cooling amount corresponding to the peak of the temperature at an early stage of the temperature rise of the central brain 15, the temperature rise of the central brain 15 can be efficiently suppressed. That is, efficient cooling of the central brain 15 can be implemented.

Furthermore, the prediction unit 116 of the cooling execution device 110 may predict that the temperature of the central brain 15 rises in a case where the object is making a motion of approaching the vehicle 100 as a movable body in the object detection result of the information processing device 10 (MoPU 12). In a case where the prediction unit 116 predicts the temperature rise of the central brain 15 in this manner, the execution unit 114 increases the cooling amount for the central brain 15. Here, in a case where the object detected by the information processing device 10 approaches the vehicle, it is further necessary to monitor the mobile object, and an arithmetic operation amount of the central brain 15 increases. Therefore, the temperature rise of the central brain 15 is expected. Therefore, insufficient cooling of the central brain 15 can be suppressed by increasing the amount of cooling of the central brain 15 by the execution unit 114. On the other hand, in a case where the object detected by the information processing device 10 moves away from the vehicle 100, the arithmetic operation amount of the central brain 15 decreases because the object is excluded from a monitoring target. The temperature drop of the central brain 15 is expected. Therefore, supercooling can be suppressed by decreasing the amount of cooling of the central brain 15 by the execution unit 114. In a case where the object detected in this manner approaches or moves away from the vehicle 100, it is possible to efficiently cool the central brain 15 by adjusting the amount of cooling of the central brain 15 by the execution unit 114.

(Tenth Embodiment)

Next, a tenth embodiment according to the present embodiment will be described while omitting or simplifying an overlapping portion with the above embodiments.

An MoPU 12 included in an information processing device 10 according to the tenth embodiment derives a z coordinate value of an object as point information from an image of the object captured by a camera 30. Hereinafter, each aspect of the information processing device 10 according to the ninth embodiment will be sequentially described.

The information processing device 10 according to a first aspect has a configuration shown in Fig. 10 similar to that of the third embodiment.

In the first aspect, the MoPU 12 derives the z coordinate value of the object as the point information from images of the object captured by a plurality of cameras 30, specifically, cameras 30L and 30R. As described above, in a case where one MoPU 12 is used, it is possible to derive an x coordinate value and a y coordinate value of the object as the point information. Here, in a case where two MoPUs 12 are used, it is possible to derive the z coordinate value of the object as the point information based on the images of the object captured by the two cameras 30 using the principle of a stereo camera. Therefore, in the first aspect, the z coordinate value of the object is derived as the point information based on the images of the object captured by the camera 30L of an MoPU 12L and the camera 30R of an MoPU 12R using the principle of the stereo camera.

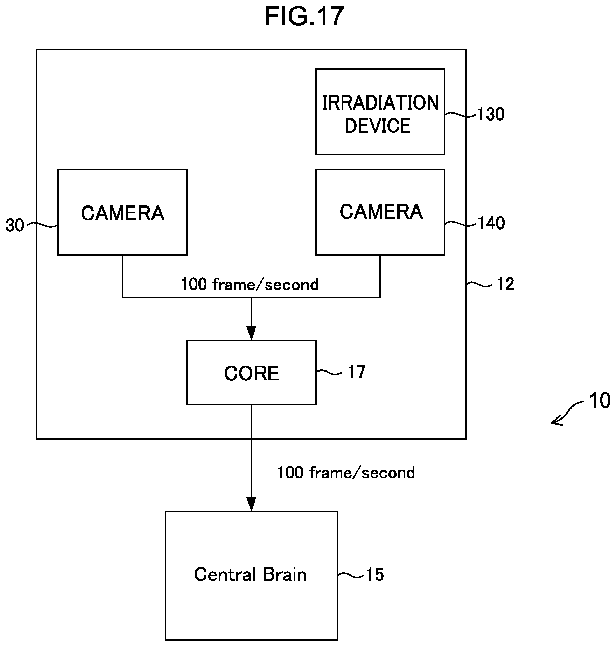

The information processing device 10 according to a second aspect has a configuration shown in Fig. 17 similar to that of the second embodiment.

In the second aspect, the MoPU 12 derives the x coordinate value, the y coordinate value, and the z coordinate value of the object as the point information from the image of the object captured by the camera 30 and a radar signal based on a reflected wave of an electromagnetic wave emitted to the object by a radar 32 from the object. As described above, the radar 32 can acquire three-dimensional point cloud data of the object based on the radar signal. That is, the radar 32 can detect the coordinate on the z axis in the above-described three-dimensional orthogonal coordinate system. In this case, the MoPU 12 derives the coordinate values of the object on three coordinate axes as the point information by combining the x coordinate value and the y coordinate value of the object imaged by the camera 30 at the same timing as a timing at which the radar 32 acquires the three-dimensional point group data of the object and the z coordinate value of the object indicated by the three-dimensional point group data, by using the principle of the stereo camera.

The information processing device 10 according to a third aspect has a configuration shown in Fig. 17. Fig. 17 is a fifth block diagram showing an example of a configuration of the information processing device 10. Fig. 17 shows only a configuration of a part of the information processing device 10.

In the third aspect, the MoPU 12 derives the z coordinate value of the object as the point information from an image of the object captured by a camera 30 and a result of imaging structured light emitted to the object by an irradiation device 130.

As shown in Fig. 17, in the MoPU 12, the image of the object captured by the camera 30 and distortion information indicating a distortion of a pattern of the structured light which is the result of imaging, by a camera 140, the structured light emitted to the object by the irradiation device 130 are input to a core 17 at a frame rate of 100 frames/second or higher. Then, the core 17 outputs the point information to a central brain 15 based on the image of the object and the distortion information that are input.

Here, a structured light method is used as one of methods for identifying a three-dimensional position or shape of the object. The structured light method irradiates the object with the structured light patterned in a dot shape, and acquires depth information from the distortion of the pattern. The structured light method is disclosed, for example, in a reference (http://ex-press.jp/wp-content/uploads/2018/10/018_teledyne_3rd.pdf).

The irradiation device 130 shown in Fig. 17 irradiates the object with the structured light. In addition, the camera 140 images the structured light emitted to the object by the irradiation device 130. Then, the camera 140 outputs the distortion information based on the distortion of the pattern of the imaged structured light to the core 17.

Here, the MoPU 12 synchronizes a timing at which the camera 30 captures the image with a timing at which the camera 140 images the structured light. Specifically, the MoPU 12 outputs a control signal to the camera 30 and the camera 140 so as to capture the image at the same timing. As a result, the number of images per second captured by the camera 30 is synchronized with the number of images per second captured by the camera 140 (for example, 1920 frames/sec). As described above, the number of images per second captured by the camera 30 and the number of images per second captured by the camera 140 are larger than a frame rate of an ultra-high-resolution camera included in an IPU 11, that is, the number of images per second captured by the ultra-high-resolution camera.

Then, the core 17 derives the z coordinate value of the object as the point information by combining the x coordinate value and the y coordinate value of the object imaged by the camera 140 at the same timing as the timing at which the structured light is imaged by the camera 30 and the distortion information based on the distortion of the pattern of the structured light.

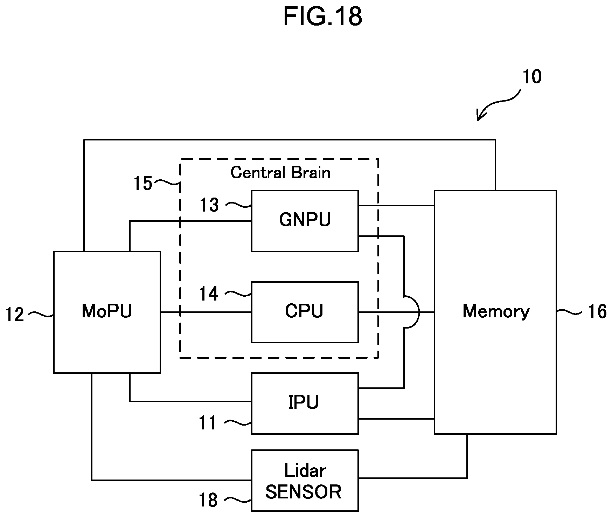

The information processing device 10 according to the fourth aspect has a configuration shown in Fig. 18. Fig. 18 is a sixth block diagram showing an example of a configuration of the information processing device 10. Fig. 18 shows only a configuration of a part of the information processing device 10.

The block diagram shown in Fig. 18 is obtained by adding a Lidar sensor 18 to the configuration of the block diagram shown in Fig. 9. The Lidar sensor 18 is a sensor that acquires point cloud data including the object present in a three-dimensional space and a road surface on which a vehicle 100 is traveling. The information processing device 10 can derive position information of the object in a depth direction, that is, the z coordinate value of the object by using the point cloud data acquired by the Lidar sensor 18. It is assumed that the point cloud data acquired by the Lidar sensor 18 is acquired at intervals longer than those of the x coordinate value and the y coordinate value of the object output from the MoPU 12. Further, the MoPU 12 includes the camera 30 similarly to the above-described aspect of the ninth embodiment.

In the fourth aspect, the MoPU 12 derives the coordinate values of the object on three coordinate axes as the point information by combining the x coordinate value and the y coordinate value of the object imaged by the camera 30 at the same timing as a timing at which the Lidar sensor 18 acquires the point cloud data of the object and the z coordinate value of the object indicated by the point cloud data, by using the principle of the stereo camera.

Here, in the fourth aspect, the MoPU 12 derives a z coordinate value of the object at time t+1 as the point information based on an x coordinate value, a y coordinate value, and a z coordinate value of the object at time t and an x coordinate value and a y coordinate value of the object at a time point (for example, time t+1) next to time t. Time t is an example of a "first time point", and time t+1 is an example of a "second time point". In the fourth aspect, the z coordinate value of the object at time t+1 is derived using shape information, that is, geometry. This will be described in detail below.

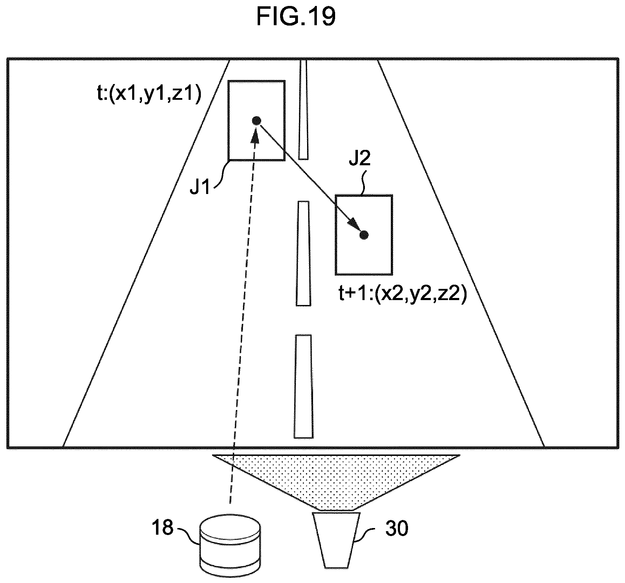

Fig. 19 is a diagram schematically showing coordinate detection in time series for the object. In Fig. 19, J indicates a position of the object represented by a rectangle, and the position of the object moves in time series from J1 to J2. In Fig. 19, the coordinate values of the object at time t at which the object is positioned at J1 are (x1,y1,z1), and the coordinate values of the object at time t+1 at which the object is positioned at J2 are (x2,y2,z2).

First, time t will be described.

The MoPU 12 derives the x coordinate value and the y coordinate value of the object from the image of the object captured by the camera 30. Subsequently, the MoPU 12 integrates the z coordinate value of the object indicated by the point cloud data acquired from the Lidar sensor 18, the x coordinate value, and the y coordinate value to derive three-dimensional coordinate values (x1,y1,z1) of the object at time t.

Next, time t+1 will be described.

The MoPU 12 derives the z coordinate value of the object at time t+1 based on the geometry of the space and a change in the x coordinate value and the y coordinate value of the object from time t to time t+1. The geometry of the space includes a shape of the road surface obtained from the image captured by the ultra-high-resolution camera included in the IPU 11 and the point cloud data of the Lidar sensor 18, and a shape of the vehicle 100.

The geometry indicating the shape of the road surface is generated in advance at time t. The MoPU 12 can simulate a case where the vehicle 100 travels on the road surface by using the geometry indicating the shape of the vehicle 100 together with the geometry indicating the shape of the road surface, and can estimate movement amounts on the respective axes of the x axis, the y axis, and the z axis.

Therefore, the MoPU 12 derives the x coordinate value and the y coordinate value of the object at time t+1 from the image of the object captured by the camera 30. The MoPU 12 can derive the z coordinate value of the object at time t+1 by calculating the movement amount on the z axis in a case where a change from the x coordinate value and the y coordinate value (x1,y1) of the object at time t to the x coordinate value and the y coordinate value (x2,y2) of the object at time t+1 is made by the simulation. Then, the MoPU 12 integrates the x coordinate value, the y coordinate value, and the z coordinate value to derive the three-dimensional coordinate values (x2,y2,z2) of the object at time t+1.

As shown in Fig. 19, since the object moves in the depth direction during movement of plane coordinates (that is, the x axis and the y axis), it is also necessary to detect the movement in a z axis direction in order to control autonomous driving of the vehicle 100 with high accuracy. Here, in some cases, the MoPU 12 is not able to acquire the z coordinate value of the object that can be derived from the point cloud data of the Lidar sensor 18 at a speed as high as those for the x coordinate value and the y coordinate value of the object. Therefore, in the fourth aspect, the MoPU 12 derives the z coordinate value of the object at time t+1 from the x coordinate value, the y coordinate value, and the z coordinate value of the object at time t and the x coordinate value and the y coordinate value of the object at time t+1. As a result, in the information processing device 10 according to the fourth aspect, the MoPU 12 can implement two-dimensional motion detection by high-frame-rate imaging and three-dimensional motion detection with high performance and low data volume.

Furthermore, in the above description, a case where the MoPU 12 derives the z coordinate value of the object as the point information from the image of the object captured by the camera 30 has been exemplified, but the technology of the disclosure is not limited to this aspect. For example, instead of the MoPU 12, the central brain 15 may derive the z coordinate value of the object as the point information. In this case, the central brain 15 derives the z coordinate value of the object as the point information by executing the processing executed by the MoPU 12 in the above description on the image of the object captured by the camera 30. As an example, the central brain 15 derives the z coordinate value of the object as the point information from the images of the object captured by the plurality of cameras 30, specifically, the cameras 30L and 30R. In this case, the central brain 15 derives the z coordinate value of the object as the point information based on the images of the object captured by the camera 30L of the MoPU 12L and the camera 30R of the MoPU 12R using the principle of the stereo camera.

(Eleventh Embodiment)

Next, an eleventh embodiment according to the present embodiment will be described while omitting or simplifying an overlapping portion with the above embodiments.

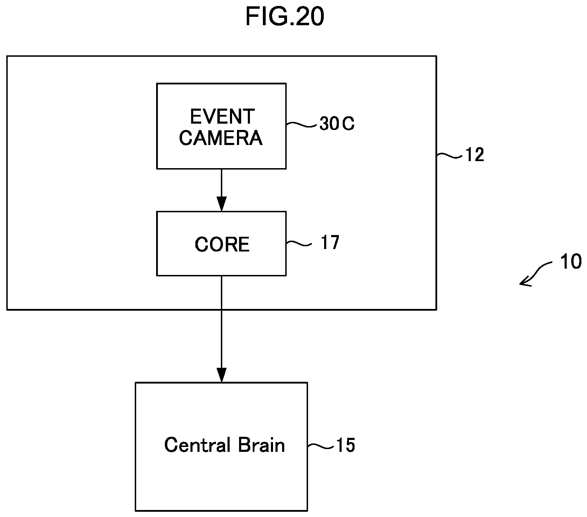

Fig. 20 is a seventh block diagram showing an example of a configuration of an information processing device 10. Fig. 20 shows only a configuration of a part of the information processing device 10.

As shown in Fig. 20, in an MoPU 12, an image of an object (hereinafter referred to as "event image") captured by an event camera 30C is input to a core 17. Then, the core 17 outputs point information to a central brain 15 based on the input event image. The event camera is disclosed, for example, in a reference (https://dendenblog.xyz/event-based-camera/).

Fig. 21 is an explanatory diagram for describing the image (event image) of the object captured by the event camera 30C. Fig. 21(A) is a diagram showing the object to be imaged by the event camera 30C. Fig. 21(B) is a diagram showing an example of the event image. Fig. 21(C) is a diagram showing an example in which the center of gravity of a difference portion between an image captured at a current time and an image captured at a previous time indicated by the event image is calculated as the point information. In the event image, the difference portion between the image captured at the current time and the image captured at the previous time is extracted as a point. Therefore, in a case where the event camera 30C is used, for example, a point of each moving portion in a person region shown in Fig. 21(A) is extracted as shown in Fig. 21(B).

Meanwhile, the core 17 extracts a person as the object and then extracts coordinates (for example, only one point) of a feature point representing the person region as shown in Fig. 21(C). As a result, the amount of data to be transferred to the central brain 15 and a memory 16 can be reduced. Since the event image can extract the person as the object at an arbitrary frame rate, in the case of the event camera 30C, the event image can be extracted at a frame rate equal to or higher than the maximum frame rate (for example, 1920 frames/second) of a camera 30 mounted on the MoPU 12 in the above embodiment, and the point information of the object can be obtained with high accuracy.

In the information processing device 10 according to the tenth embodiment, the MoPU 12 may include a visible light camera 30A in addition to the event camera 30C, similarly to the above-described embodiment. In this case, in the MoPU 12, a visible light image of the object captured by the visible light camera 30A and the event image are input to the core 17. Then, the core 17 outputs the point information to the central brain 15 based on at least one of the visible light image and the event image that are input.

For example, in a case where the object can be identified from the visible light image of the object captured by the visible light camera 30A, the core 17 outputs the point information based on the visible light image. On the other hand, in a case where the object is not identified from the visible light image due to a predetermined factor, the core 17 outputs the point information based on the event image. The predetermined factor includes at least one of a case where a movement speed of the object is equal to or higher than a predetermined value and a case where a light quantity change of ambient light per unit time is equal to or larger than a predetermined value. For example, in a case where the object is not identified from the visible light image due to a high speed of a motion of the object, the core 17 identifies the object based on the event image, and outputs an x coordinate value and a y coordinate value of the object as the point information. Furthermore, in a case where the object is not identified from the visible light image due to a sudden light quantity change of the ambient light such as backlight, the core 17 identifies the object based on the event image, and outputs the x coordinate value and the y coordinate value of the object as the point information. With such a configuration, in the information processing device 10, it is possible to selectively use the camera 30 that images the object according to the predetermined factor.

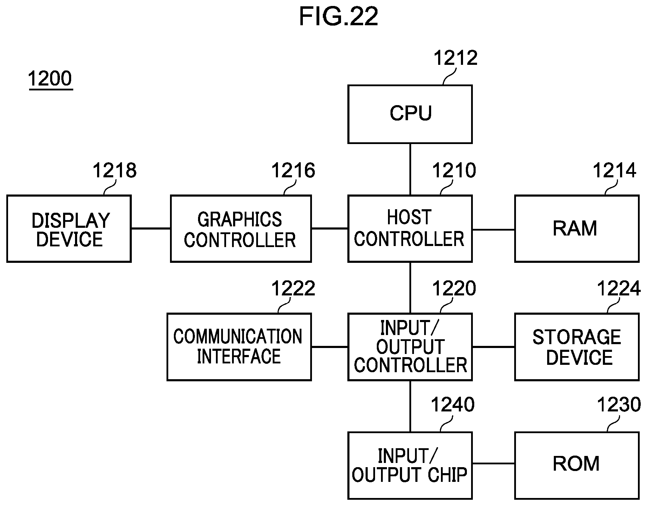

Fig. 22 schematically shows an example of a hardware configuration of a computer 1200 that functions as the management server 101, the SoCBox 400, the cooling execution device 500, the information processing device 10, or the cooling execution device 110. A program installed in the computer 1200 can cause the computer 1200 to function as one or more "units" of the device according to the present embodiment, or cause the computer 1200 to perform an operation associated with the device according to the embodiment or one or more "units" thereof, and/or can cause the computer 1200 to execute a process according to the embodiment or a stage of the process. Such a program may be executed by a CPU 1212 to cause the computer 1200 to perform a certain operation associated with some or all of the blocks in the flowcharts and block diagrams described herein.

The computer 1200 according to each embodiment described above includes the CPU 1212, a RAM 1214, and a graphics controller 1216, which are mutually connected by a host controller 1210. The computer 1200 also includes input/output units such as a communication interface 1222, a storage device 1224, a digital versatile disk (DVD) drive, and an IC card drive, which are connected to the host controller 1210 via an input/output controller 1220. The DVD drive may be a DVD-ROM drive, a DVD-RAM drive, or the like. The storage device 1224 may be a hard disk drive, a solid state drive, or the like. The computer 1200 also includes a read only memory (ROM) 1230 and legacy input/output units such as a keyboard, which are connected to the input/output controller 1220 via an input/output chip 1240.

The CPU 1212 operates according to the program stored in the ROM 1230 and the RAM 1214, thereby controlling each unit. The graphics controller 1216 acquire image data generated by the CPU 1212 in a frame buffer or the like provided in the RAM 1214 or itself, and causes the image data to be displayed on a display device 1218.

The communication interface 1222 communicates with other electronic devices via a network. The storage device 1224 stores the program and data to be used by the CPU 1212 in the computer 1200. The DVD drive reads the program or data from a DVD-ROM or the like and provides the program or data to the storage device 1224. The IC card drive reads the program and data from an IC card and/or writes the program and data to the IC card.

The ROM 1230 stores therein a boot program to be executed by the computer 1200 at the time of activation and/or a program that depends on hardware of the computer 1200. The input/output chip 1240 may also connect various input/output units to the input/output controller 1220 via a USB port, a parallel port, a serial port, a keyboard port, a mouse port, or the like.

The program is provided by a computer-readable storage medium such as the DVD-ROM or the IC card. The program is read from the computer-readable storage medium, installed in the storage device 1224, the RAM 1214, or the ROM 1230, which is also an example of the computer-readable storage medium, and executed by the CPU 1212. Information processing described in these programs is read by the computer 1200 and provides cooperation between the programs and various types of hardware resources described above. The device or method may be configured by implementing operation or processing of information according to the use of the computer 1200.

For example, in a case where communication is performed between the computer 1200 and an external device, the CPU 1212 may execute a communication program loaded into the RAM 1214 and instruct the communication interface 1222 to execute communication processing based on processing described in the communication program. Under the control of the CPU 1212, the communication interface 1222 reads transmission data stored in a transmission buffer region provided in a recording medium such as the RAM 1214, the storage device 1224, the DVD-ROM, or the IC card, transmits the read transmission data to the network, or writes reception data received from the network to a reception buffer region or the like provided on the recording medium.

In addition, the CPU 1212 may read a necessary part of or the entire file or database stored in an external recording medium such as the storage device 1224, the DVD drive (DVD-ROM), the IC card, or the like into the RAM 1214, and may execute various types of processing on the data on the RAM 1214. Next, the CPU 1212 may write back the processed data to the external recording medium.

Various types of information such as various types of programs, data, tables, and databases may be stored in a recording medium and subjected to the information processing. The CPU 1212 may execute various types of processing on the data read from the RAM 1214, the various types of processing including various types of operations, the information processing, condition determination, conditional branching, unconditional branching, and information search/replacement, which are described throughout the disclosure and designated by a command sequence of a program, and writes back the results to the RAM 1214. In addition, the CPU 1212 may search for information in a file, a database, or the like in the recording medium. For example, in a case where a plurality of entries each having an attribute value of a first attribute associated with an attribute value of a second attribute are stored in the recording medium, the CPU 1212 may search for an entry in which the attribute value of the first attribute satisfies a designated condition among the plurality of entries, read the attribute value of the second attribute stored in the entry, and thereby acquire the attribute value of the second attribute associated with the first attribute satisfying a predetermined condition.

The program or software module described above may be stored in a computer-readable storage medium on the computer 1200 or in the vicinity of the computer 1200. Furthermore, a recording medium such as a hard disk or a RAM provided in a server system connected to a dedicated communication network or the Internet can be used as the computer-readable storage medium, thereby providing a program to the computer 1200 via the network.

The blocks in the flowcharts and block diagrams in each embodiment described above may represent stages of a process in which the operation is performed or "units" of the device that are responsible for performing the operation. Certain stages and "units" may be implemented by a dedicated circuit, a programmable circuit provided together with a computer-readable instruction stored on a computer-readable storage medium, and/or a processor provided together with the computer-readable instruction stored on the computer-readable storage medium. The dedicated circuit may include a digital and/or analog hardware circuit, and may include an integrated circuit (IC) and/or a discrete circuit. The programmable circuit may include a reconfigurable hardware circuit including, for example, AND, OR, XOR, NAND, NOR, and other logical operations, a flip-flop, a register, and a memory element, such as a field programmable gate array (FPGA) and a programmable logic array (PLA).

The computer-readable storage medium may include any tangible device capable of storing an instruction to be executed by a suitable device, so that the computer-readable storage medium having the instruction stored therein includes an article including an instruction that may be executed to create means for performing the operation specified in the flowcharts or block diagrams. Examples of the computer-readable storage medium may include an electronic storage medium, a magnetic storage medium, an optical storage medium, an electromagnetic storage medium, and a semiconductor storage medium. More specific examples of the computer-readable storage medium may include a floppy (registered trademark) disk, a diskette, a hard disk, a random access memory (RAM), a read only memory (ROM), an erasable programmable read only memory (EPROM or flash memory), an electrically erasable programmable read only memory (EEPROM), a static random access memory (SRAM), a compact disc read only memory (CD-ROM), a digital versatile disk (DVD), a Blu-Ray disk, a memory stick, and an integrated circuit card.

The computer-readable instruction may include a source code or an object code described in any combination of one or more programming languages, including an assembler instruction, an instruction-set-architecture (ISA) instruction, a machine instruction, a machine-dependent instruction, a microcode, a firmware instruction, state setting data, or an object-oriented programming language such as Smalltalk (registered trademark), JAVA (registered trademark), or C++, and a procedural programming language according to the related art, such as the "C" programming language or similar programming languages.

The computer-readable instruction may be provided for a processor of a general purpose computer, a special purpose computer, or another programmable data processing device, or a programmable circuit, either locally or via a local area network (LAN) or a wide area network (WAN) such as the Internet, to cause the processor of the general purpose computer, the special purpose computer, or the another programmable data processing device or the programmable circuit to execute the computer-readable instruction to generate means for performing the operation designated in the flowcharts or block diagrams. Examples of the processor include a computer processor, a processing unit, a microprocessor, a digital signal processor, a controller, and a microcontroller.

Although the invention has been described with reference to the embodiments, the technical scope of the invention is not limited to the scope described in the embodiments. It is apparent to those skilled in the art that various modifications or improvements can be made to the above embodiments. It is apparent from the description of the claims that such changed modes or improved modes can also be included in the technical scope of the invention.

It should be noted that an order of execution of processing such as operations, procedures, steps, and stages in the devicees, systems, programs, and methods shown in the claims, the specification, and the drawings can be implemented in any order unless "before", "prior to", or the like is explicitly stated, and unless the output of the previous processing is used in the later processing. Even in a case where the operation flow in the claims, the specification, and the drawings is described using the terms "first,", "next,", and the like for convenience, it does not mean that it is essential to execute the operation flow in this order.

In the embodiments, the processing to be executed by each processor (such as the IPU 11, the MoPU 12, or the central brain 15) is merely an example, and a processor that executes each processing is not limited. For example, the processing executed by the MoPU 12 in the embodiments may be executed by the central brain 15 instead of the MoPU 12, or may be executed by a processor other than the IPU 11, the MoPU 12, and the central brain 15.

<Supplementary Note 1>

(1) An information processing device including:

a first processor that outputs point information that represents an imaged object as a point in an image of the object captured by a first camera; and
a second processor that outputs identification information obtained by identifying the imaged object in an image of the object captured by a second camera oriented in a direction corresponding to a direction in which the first camera is oriented.

(2) The information processing device according to (1), further including a third processor that associates the point information output from the first processor with the identification information output from the second processor.
(3) The information processing device according to (1) or (2), in which

a frame rate of the first camera is variable, and
the first processor changes the frame rate of the first camera according to a predetermined factor.

(4) The information processing device according to (3), in which
the first processor calculates a score for an external environment for a predetermined target.
(5) The information processing device according to (4), in which
the first processor changes the frame rate of the first camera according to the calculated score for the external environment.
(6) An information processing method in which a computer executes processing of:

outputting point information that represents an imaged object as a point in an image of the object captured by a first camera; and
outputting identification information obtained by identifying the imaged object in an image of the object captured by a second camera oriented in a direction corresponding to a direction in which the first camera is oriented.

(7) An information processing program for causing a computer to execute processing of:

outputting point information that represents an imaged object as a point in an image of the object captured by a first camera; and
outputting identification information obtained by identifying the imaged object in an image of the object captured by a second camera oriented in a direction corresponding to a direction in which the first camera is oriented.

<Supplementary Note 2>

(1) An information processing device including:

a first processor that outputs coordinate values of a point indicating an existence position of an imaged object in an image of the object captured by a first camera on at least two coordinate axes in a three-dimensional orthogonal coordinate system;

a second processor that outputs identification information obtained by identifying the imaged object in an image of the object captured by a second camera oriented in a direction corresponding to a direction in which the first camera is oriented; and

a third processor that associates the coordinate values output from the first processor with the identification information output from the second processor.

(2) The information processing device according to (1), in which
the first processor outputs the coordinate values of at least two diagonal points at vertices of a polygon surrounding a contour of the object recognized from the image captured by the first camera.

(3) The information processing device according to (2), in which
the first processor outputs the coordinate values of a plurality of vertices of the polygon surrounding the contour of the object recognized from the image captured by the first camera.

(4) An information processing method in which a computer executes processing of:

outputting coordinate values of a point indicating an existence position of an imaged object in an image of the object captured by a first camera on at least two coordinate axes in a three-dimensional orthogonal coordinate system;

outputting identification information obtained by identifying the imaged object in an image of the object captured by a second camera oriented in a direction corresponding to a direction in which the first camera is oriented; and

associating the coordinate values with the identification information.

(5) An information processing program for causing a computer to execute processing of:

outputting coordinate values of a point indicating an existence position of an imaged object in an image of the object captured by a first camera on at least two coordinate axes in a three-dimensional orthogonal coordinate system;

outputting identification information obtained by identifying the imaged object in an image of the object captured by a second camera oriented in a direction corresponding to a direction in which the first camera is oriented; and

associating the coordinate values with the identification information.

<Supplementary Note 3>

(1) An information processing device including:

a first processor that outputs point information that represents an imaged object as a point in an image of the object captured by a first camera;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor, and controls autonomous driving of a movable body based on the point information and the identification information.

(2) The information processing device according to (1), in which
the third processor calculates a control variable for controlling the autonomous driving of the movable body based on detection information detected by a detection unit, and controls the autonomous driving of the movable body based on the calculated control variable, the point information, and the identification information.

(3) An information processing method in which a computer executes processing of:

outputting point information that represents an imaged object as a point in an image of the object captured by a first camera;

outputting identification information obtained by identifying the imaged object in an image of the object captured by a second camera oriented in a direction corresponding to a direction in which the first camera is oriented; and

associating the point information with the identification information, and controlling autonomous driving of a movable body based on the point information and the identification information.

(4) An information processing program for causing a computer to execute processing of:

outputting point information that represents an imaged object as a point in an image of the object captured by a first camera;

outputting identification information obtained by identifying the imaged object in an image of the object captured by a second camera oriented in a direction corresponding to a direction in which the first camera is oriented; and

associating the point information with the identification information, and controlling autonomous driving of a movable body based on the point information and the identification information.

<Supplementary Note 4>

(1) An information processing device including:

a first processor that outputs point information that represents an imaged object as a point in an image of the object captured by a first camera;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor, in which

a frame rate of the first camera is higher than a frame rate of the second camera.

(2) The information processing device according to (1), in which
the frame rate of the first camera is 10 times or more the frame rate of the second camera.

(3) The information processing device according to (2), in which the frame rate of the first camera is 100 frames/second or higher, and the frame rate of the second camera is 10 frames/second.

(4) An information processing method in which a computer executes processing of:

outputting point information that represents an imaged object as a point in an image of the object captured by a first camera;

outputting identification information obtained by identifying the imaged object in an image of the object captured by a second camera having a frame rate lower than a frame rate of the first camera and oriented in a direction corresponding to a direction in which the first camera is oriented; and

associating the point information with the identification information.

(5) An information processing program for causing a computer to execute processing of:

outputting point information that represents an imaged object as a point in an image of the object captured by a first camera;

outputting identification information obtained by identifying the imaged object in an image of the object captured by a second camera having a frame rate lower than a frame rate of the first camera and oriented in a direction corresponding to a direction in which the first camera is oriented; and

associating the point information with the identification information.

<Supplementary Note 5>

(1) An information processing device including:

a first processor that outputs point information that represents an imaged object as a point in an image of the object captured by a first camera;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor, in which

the first processor calculates a risk level for movement of a predetermined movable body as a score for an external environment for the movable body based on detection information detected by a detection unit and the point information.

(2) The information processing device according to (1), in which

a frame rate of the first camera is variable, and
the first processor changes the frame rate of the first camera according to the calculated risk level.

(3) The information processing device according to (1) or (2), in which
the risk level indicates the degree of risk of a place where the movable body is to travel in future.

(4) An information processing device including:

a first processor that outputs point information that represents an imaged object as a point in an image of the object captured by a first camera;
a second processor that outputs identification information obtained by identifying the imaged object in an image of the object captured by a second camera oriented in a direction corresponding to a direction in which the first camera is oriented; and
a third processor that associates the point information output from the first processor with the identification information output from the second processor, in which
the third processor calculates a risk level for movement of a predetermined movable body as a score for an external environment for the movable body based on detection information detected by a detection unit and the point information.

(5) The information processing device according to (4), in which

a frame rate of the first camera is variable, and
the third processor outputs an instruction to change the frame rate of the first camera according to the calculated risk level to the first processor.

(6) An information processing method in which a computer executes processing of:

outputting point information that represents an imaged object as a point in an image of the object captured by a first camera;
outputting identification information obtained by identifying the imaged object in an image of the object captured by a second camera oriented in a direction corresponding to a direction in which the first camera is oriented;
associating the point information with the identification information; and
calculating a risk level for movement of a predetermined movable body as a score for an external environment for the movable body based on detection information detected by a detection unit and the point information.

(7) An information processing program for causing a computer to execute processing of:

outputting point information that represents an imaged object as a point in an image of the object captured by a first camera;
outputting identification information obtained by identifying the imaged object in an image of the object captured by a second camera oriented in a direction corresponding to a direction in which the first camera is oriented;
associating the point information with the identification information; and
calculating a risk level for movement of a predetermined movable body as a score for an external environment for the movable body based on detection information detected by a detection unit and the point information.

<Supplementary Note 6>

(1) An information processing device including:

a first processor that outputs point information that represents an imaged object as a point based on at least one of a visible light image and an infrared image of the object captured by a first camera;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor.

(2) The information processing device according to (1), in which
the first processor outputs the point information based on the infrared image of the object captured by an infrared camera included in the first camera in a case where the object is not identified from the visible light image of the object captured by a visible light camera included in the first camera due to a predetermined factor.
(3) The information processing device according to (2), in which
the first processor synchronizes a timing at which the visible light camera captures the visible light image with a timing at which the infrared camera captures the infrared image.
(4) An information processing method in which a computer executes processing of:

outputting point information that represents an object as a point based on at least one of a visible light image and an infrared image of the object captured by a first camera;

outputting identification information obtained by identifying the imaged object in an image of the object captured by a second camera oriented in a direction corresponding to a direction in which the first camera is oriented; and

associating the point information with the identification information.

(5) An information processing program for causing a computer to execute processing of:

outputting point information that represents an object as a point based on at least one of a visible light image and an infrared image of the object captured by a first camera;

outputting identification information obtained by identifying the imaged object in an image of the object captured by a second camera oriented in a direction corresponding to a direction in which the first camera is oriented; and

associating the point information with the identification information.

<Supplementary Note 7>

(1) An information processing device including:

a first processor that outputs point information that represents an imaged object as a point in an image of the object captured by a first camera and a radar signal based on a reflected wave of an electromagnetic wave emitted to the object by a radar from the object;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor.

(2) The information processing device according to (1), in which
the first processor synchronizes a timing at which the first camera captures the image with a timing at which the radar acquires three-dimensional point cloud data of the object based on the radar signal.
(3) The information processing device according to (1) or (2), in which
the number of images per unit time captured by the first camera and the number of pieces of three-dimensional point cloud data per unit time acquired by the radar are larger than the number of images per unit time captured by the second camera.
(4) An information processing method in which a computer executes processing of:

outputting point information that represents an imaged object as a point in an image of the object captured by a first camera and a radar signal based on a reflected wave of an electromagnetic wave emitted to the object by a radar from the object;

outputting identification information obtained by identifying the imaged object in an image of the object captured by a second camera oriented in a direction corresponding to a direction in which the first camera is oriented; and associating the point information with the identification information.

(5) An information processing program for causing a computer to execute processing of:

outputting point information that represents an imaged object as a point in an image of the object captured by a first camera and a radar signal based on a reflected wave of an electromagnetic wave emitted to the object by a radar from the object;

outputting identification information obtained by identifying the imaged object in an image of the object captured by a second camera oriented in a direction corresponding to a direction in which the first camera is oriented; and associating the point information with the identification information.

<Supplementary Note 8>

(1) An information processing device including:

a first processor that outputs point information that represents an imaged object as a point in an image of the object captured by a first camera;

a second processor that outputs label information indicating a type of the imaged object in an image of the object captured by a second camera oriented in a direction corresponding to a direction in which the first camera is oriented; and

a third processor that associates the point information output from the first processor with the label information output from the second processor.

(2) The information processing device according to (1), in which
the third processor associates position information of the object indicated by the point information with the label information for the object present at a position indicated by the position information.

(3) The information processing device according to (2), in which the third processor associates the point information output from the first processor with the label information at the same timing as a timing at which the second processor outputs the label information.

(4) The information processing device according to (2) or (3), in which
the third processor associates new point information with the label information in a case where the new point information is output from the first processor after the point information and the label information are associated with each other.

(5) An information processing method in which a computer executes processing of:

outputting point information that represents an imaged object as a point in an image of the object captured by a first camera;

outputting label information indicating a type of the imaged object in an image of the object captured by a second camera oriented in a direction corresponding to a direction in which the first camera is oriented; and

associating the point information with the label information.

(6) An information processing program for causing a computer to execute processing of:

outputting point information that represents an imaged object as a point in an image of the object captured by a first camera;

outputting label information indicating a type of the imaged object in an image of the object captured by a second camera oriented in a direction corresponding to a direction in which the first camera is oriented; and

associating the point information with the label information.

<Supplementary Note 9>

(1) A cooling execution device including:

an acquisition unit that outputs point information that represents an object as a point in images of the object captured by a plurality of cameras oriented in corresponding directions and identification information for identifying the object, and acquires a detection result for the object from an information processing device that associates the point information with the identification information; and

an execution unit that performs cooling of the information processing device based on the detection result acquired by the acquisition unit.

(2) The cooling execution device according to (1), further including a prediction unit that predicts an operation status of the information processing device based on the detection result acquired by the acquisition unit, in which

the execution unit performs the cooling of the information processing device based on a prediction result for the operation status of the information processing device from the prediction unit.

(3) The cooling execution device according to (2), in which

the prediction unit predicts a temperature change of the information processing device, and

the execution unit performs the cooling of the information processing device by using cooling means corresponding to a prediction result for the temperature change of the information processing device from the prediction unit.

(4) The cooling execution device according to any one of (1) to (3), in which
the detection result acquired by the acquisition unit is the point information.

(5) A cooling execution method in which a computer executes processing of:

outputting point information that represents an object as a point in images of the object captured by a plurality of cameras oriented in corresponding directions and identification information for identifying the object, and acquiring a detection result for the object from an information processing device that associates the point information with the identification information; and

performing cooling of the information processing device based on the acquired detection result.

(6) A cooling execution program for causing a computer to execute processing of:

outputting point information that represents an object as a point in images of the object captured by a plurality of cameras oriented in corresponding directions and identification information for identifying the object, and acquiring a detection result for the object from an information processing device that associates the point information with the identification information; and

performing cooling of the information processing device based on the acquired detection result.

<Supplementary Note 10>

(1) An information processing device including:

a first processor that outputs point information that represents an imaged object as a point in an image of the object captured by a first camera;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor, in which

the first processor derives coordinate values of a point indicating an existence position of the object as the point information in a depth direction of the object in a three-dimensional orthogonal coordinate system from the image of the object captured by the first camera.

(2) The information processing device according to (1), in which
the first processor derives, as the point information, a coordinate value in the depth direction from images of the object captured by a plurality of the first cameras.

(3) The information processing device according to (1) or (2), in which
the first processor derives, as the point information, coordinate values in a width direction, a height direction, and the depth direction of the object from the image of the object captured by the first camera and a radar signal based on a reflected wave of an electromagnetic wave emitted to the object by a radar from the object.

(4) The information processing device according to any one of (1) to (3), in which

the first processor derives, as the point information, coordinate values in a width direction, a height direction, and the depth direction of the object from the image of the object captured by the first camera and a result of imaging structured light emitted to the object by an irradiation device.

(5) The information processing device according to any one of (1) to (4), in which

the first processor derives, as the point information, a coordinate value in the depth direction at a second time point from coordinate values in a width direction, a height direction, and the depth direction of the object in the three-dimensional orthogonal coordinate system at a first time point and coordinate values in the width direction and the height direction at the second time point which is a time point next to the first time point.

(6) An information processing device including:

a first processor that outputs point information that represents an imaged object as a point in an image of the object captured by a first camera;

a second processor that outputs identification information obtained by identifying the imaged object in an image of the object captured by a second camera oriented in a direction corresponding to a direction in which the first camera is oriented; and

a third processor that associates the point information output from the first processor with the identification information output from the second processor, in which

the third processor derives coordinate values of a point indicating an existence position of the object as the point information in a depth direction of the object in a three-dimensional orthogonal coordinate system from the image of the object captured by the first camera.

(7) An information processing method in which a computer executes processing of:

outputting point information that represents an imaged object as a point in an image of the object captured by a first camera;

outputting identification information obtained by identifying the imaged object in an image of the object captured by a second camera oriented in a direction corresponding to a direction in which the first camera is oriented;

associating the point information with the identification information; and

deriving coordinate values of a point indicating an existence position of the object as the point information in a depth direction of the object in a three-dimensional orthogonal coordinate system from the image of the object captured by the first camera.

(8) An information processing program for causing a computer to execute processing of:

outputting point information that represents an imaged object as a point in an image of the object captured by a first camera;

outputting identification information obtained by identifying the imaged object in an image of the object captured by a second camera oriented in a direction corresponding to a direction in which the first camera is oriented;

associating the point information with the identification information; and

deriving coordinate values of a point indicating an existence position of the object as the point information in a depth direction of the object in a three-dimensional orthogonal coordinate system from the image of the object captured by the first camera.

<Supplementary Note 11>

(1) An information processing device including:

a first processor that outputs point information that represents the imaged object as a point in an image of the object captured by an event camera;

a second processor that outputs identification information obtained by identifying the imaged object in an image of the object captured by a second camera oriented in a direction corresponding to a direction in which the event camera is oriented; and

a third processor that associates the point information output from the first processor with the identification information output from the second processor.

(2) The information processing device according to (1), in which
the first processor outputs the point information based on the image of the object captured by the event camera in a case where the object is not identified from a visible light image of the object captured by a visible light camera due to a predetermined factor.

(3) The information processing device according to (2), in which
the predetermined factor includes at least one of a case where a movement speed of the object is equal to or higher than a predetermined value and a case where a light quantity change of ambient light per unit time is equal to or larger than a predetermined value.

(4) The information processing device according to any one of (1) to (3), in which the event camera is a camera that outputs an event image representing a difference portion between an image captured at a current time and an image captured at a previous time.

(5) An information processing method in which a computer executes processing of:

outputting point information that represents an imaged object as a point in an image of the object captured by an event camera;
outputting identification information obtained by identifying the imaged object in an image of the object captured by a second camera oriented in a direction corresponding to a direction in which the event camera is oriented; and
associating the point information with the identification information.

(6) An information processing program for causing a computer to execute processing of:

outputting point information that represents an imaged object as a point in an image of the object captured by an event camera;
outputting identification information obtained by identifying the imaged object in an image of the object captured by a second camera oriented in a direction corresponding to a direction in which the event camera is oriented; and
associating the point information with the identification information.

The disclosures of the following Japanese patent applications are incorporated herein by reference in their entireties. All documents, patent applications, and technical standards mentioned herein are incorporated herein by reference to the same extent as if each individual document, patent application, and technical standard were specifically and individually stated.

Japanese Patent Application No. 2022-170165
Japanese Patent Application No. 2022-172777
Japanese Patent Application No. 2022-175679
Japanese Patent Application No. 2022-181362
Japanese Patent Application No. 2022-182131
Japanese Patent Application No. 2022-186040
Japanese Patent Application No. 2022-187648
Japanese Patent Application No. 2022-187649
Japanese Patent Application No. 2022-189546
Japanese Patent Application No. 2022-210884
Japanese Patent Application No. 2023-036967
Japanese Patent Application No. 2023-036975
Japanese Patent Application No. 2023-078024
Japanese Patent Application No. 2023-080388

**Claims**

1. A cooling execution device comprising:

an acquisition unit that acquires a detection result of detecting an object related to operation of a control device mounted on a vehicle, the control device controlling autonomous driving of the vehicle; and
an execution unit that is configured to perform cooling of the control device based on the detection result.

2. The cooling execution device according to claim 1, wherein
the acquisition unit extracts, as the detection result, a point indicating an existence position of the object from an image of one frame of the object, and acquires motion information indicating a motion of the point indicating the existence position of the object along a predetermined coordinate axis at a frame rate of 100 frames/second or higher.

3. The cooling execution device according to claim 2, further comprising a prediction unit that predicts the operation of the control device by using the detection result, wherein
the prediction unit predicts the operation of the control device by using a learning model generated by machine learning using, as learning data, the detection result and an operation status of the control device when the detection result is acquired.

4. The cooling execution device according to claim 3, wherein

    the prediction unit further predicts a temperature change of each of a plurality of portions in the control device, and
    the execution unit controls cooling of the portion in the control device.

5. A cooling execution method in which a computer executes processing of:

    acquiring a detection result of detecting an object related to operation of a control device mounted on a vehicle, the control device controlling autonomous driving of the vehicle; and
    performing cooling of the control device based on the detection result.

6. A cooling execution program for causing a computer to execute processing of:

    acquiring a detection result of detecting an object related to operation of a control device mounted on a vehicle, the control device controlling autonomous driving of the vehicle; and
    performing cooling of the control device based on the detection result.

7. The cooling execution device according to claim 1, wherein
the cooling execution device comprises:

    an acquisition unit that acquires a detection result for an object from an information processing device, the information processing device being configured to output point information representing the object as a point in images of the object captured by a plurality of cameras oriented in corresponding directions and to output identification information for identifying the object and associate the point information with the identification information; and
    an execution unit that is configured to perform cooling of the information processing device based on the detection result acquired by the acquisition unit.

8. The cooling execution device according to claim 7, wherein
the execution unit causes the cooling of the information processing device to be stopped in a case where a predetermined condition is satisfied.

9. The cooling execution device according to claim 8, wherein
the execution unit causes the cooling of the information processing device to be stopped in a case where a condition that the object detected by the information processing device is no longer detected as the predetermined condition is satisfied.

10. The cooling execution device according to claim 8, wherein
the execution unit causes the cooling of the information processing device to be stopped in a case where a condition that the object detected by the information processing device is moving toward an outside of a detection range as the predetermined condition is satisfied.

11. The cooling execution device according to any one of claims 8 to 10, wherein
the execution unit causes the cooling of the information processing device to be stopped after a predetermined time elapses in a case where the predetermined condition is satisfied.

12. The cooling execution device according to claim 8, further comprising a prediction unit that predicts an operation status of the information processing device based on the detection result acquired by the acquisition unit, wherein
the execution unit is configured to perform the cooling of the information processing device based on a prediction result for the operation status of the information processing device from the prediction unit.

13. The cooling execution device according to claim 12, wherein

the prediction unit predicts a temperature change of the information processing device, and
the execution unit is configured to perform the cooling of the information processing device by using cooling means corresponding to a prediction result for the temperature change of the information processing device from the prediction unit.

14. The cooling execution device according to claim 12, wherein

the prediction unit predicts a time when a temperature of the information processing device becomes equal to or lower than a threshold, and
the execution unit causes the cooling of the information processing device to be stopped in a case where a condition that the time predicted by the prediction unit is reached as the predetermined condition is satisfied.

15. The cooling execution device according to claim 8, wherein
the detection result acquired by the acquisition unit is the point information.

16. The cooling execution device according to claim 7, further comprising:

a prediction unit that predicts an operation status and a temperature change of the information processing device based on the detection result acquired by the acquisition unit; and
an execution unit that is configured to perform the cooling of the information processing device based on a prediction result for the operation status of the information processing device from the prediction unit and adjusts a cooling amount for the information processing device based on a prediction result for the temperature change of the information processing device from the prediction unit.

17. The cooling execution device according to claim 16, wherein

the prediction unit further predicts a peak of a temperature of the information processing device, and
the execution unit is configured to perform the cooling of the information processing device with a cooling amount corresponding to the peak of the temperature predicted by the prediction unit.

18. The cooling execution device according to claim 17, wherein
the execution unit is configured to perform the cooling of the information processing device such that the cooling amount corresponding to the peak of the temperature is obtained before reaching the peak of the temperature predicted by the prediction unit.

19. The cooling execution device according to claim 17, wherein

the information processing device is mounted on a movable body,
the prediction unit predicts that the temperature of the information processing device rises in a case where the object is making a motion of approaching the movable body in the detection result, and
the execution unit increases the cooling amount for the information processing device in a case where a temperature rise of the information processing device is predicted by the prediction unit.

20. A cooling execution method in which a computer executes processing of:

acquiring a detection result for an object from an information processing device that outputs point information representing the object as a point in images of the object captured by a plurality of cameras oriented in corresponding directions and identification information for identifying the object and associate the point information with the identification information; and
performing cooling of the information processing device based on the acquired detection result.

21. A cooling execution program for causing a computer to execute processing of:

acquiring a detection result for an object from an information processing device that outputs point information representing the object as a point in images of the object captured by a plurality of cameras oriented in corresponding directions and identification information for identifying the object and associate the point information with the identification information; and

performing cooling of the information processing device based on the acquired detection result.

22. A vehicle including a control device that controls autonomous driving, the vehicle comprising:

a power unit including a motor;

an acquisition unit that acquires a detection result of detecting an object related to operation of the control device; and

an execution unit that is configured to perform cooling of the control device based on the detection result, wherein the control device controls each unit of the vehicle including the cooling using regenerative power generated by the motor at a time of deceleration of the vehicle according to the detection result.

23. The vehicle according to claim 22, wherein the control device controls a deceleration of the vehicle such that each unit of the vehicle is controlled only using the regenerative power from when the deceleration of the vehicle according to the detection result is started to when the vehicle stops.

24. The vehicle according to claim 22, further comprising a brake actuator that performs a brake operation of the vehicle, wherein the control device controls the brake actuator using the regenerative power at a time of the deceleration of the vehicle according to the detection result.

25. The vehicle according to claim 23 or 24, further comprising a steering actuator that performs a steering operation of the vehicle, wherein the control device controls the steering actuator using the regenerative power at a time of the deceleration of the vehicle according to the detection result.

26. The vehicle according to claim 22, wherein the acquisition unit extracts, as the detection result, a point indicating an existence position of the object from an image of one frame of the object, and acquires motion information indicating a motion of the point indicating the existence position of the object along a predetermined coordinate axis at a frame rate of 100 frames/second or higher.

27. The vehicle according to claim 26, further comprising a prediction unit that predicts the operation of the control device by using the detection result, wherein the prediction unit predicts the operation of the control device by using a learning model generated by machine learning using, as learning data, the detection result and an operation status of the control device when the detection result is acquired.

28. The vehicle according to claim 27, wherein

the prediction unit further predicts a temperature change of each of a plurality of portions in the control device, and the execution unit controls cooling of the portion in the control device.

# FIG.1

# FIG.2

MANAGEMENT SERVER 100

| INFORMATION ACQUISITION UNIT | 102 |
| MODEL GENERATION UNIT | 104 |
| MODEL PROVIDING UNIT | 106 |

SENSOR 210

| CAMERA | 211 | IMU | 215 |
| LiDAR | 212 | GNSS | 216 |
| MILLIMETER WAVE | 213 | MoPU | 217 |
| ULTRASOUND | 214 | TEMPERATURE | 218 |

SoCBox 400

# FIG.3

310

**SENSOR**

| | |
|---|---|
| CAMERA ∽311 | IMU ∽315 |
| LiDAR ∽312 | GNSS ∽316 |
| MILLIMETER WAVE ∽313 | MoPU ∽317 |
| ULTRASOUND ∽314 | TEMPERATURE ∽318 |

500

**COOLING EXECUTION DEVICE**

INFORMATION ACQUISITION UNIT ∽502

COOLING EXECUTION UNIT ∽504

MODEL STORAGE UNIT ∽506

PREDICTION UNIT ∽508

400

**SoCBox**

600∽ | COOLING MEANS | ... | COOLING MEANS |

FIG.4

FIG.5

## FIG.6

# FIG.7

FIG.8

# FIG.9

# FIG.10

12L

Left MoPU
(Left eye)

32L    30L    34L

RADAR    CAMERA    INFRARED CAMERA

17L

CORE

12R

Right MoPU
(Right eye)

32R    30R    34R

RADAR    CAMERA    INFRARED CAMERA

17R

CORE

10

11

IPU

1920 frames/sec

1920 frames/sec

Multiple frames/sec
120 240 480 960 1920

Central Brain — 15

FIG.11

$(X_{31}, Y_{31})$

23

$(X_{11}, Y_{11})$

21

$(X_{32}, Y_{32})$

$(X_{12}, Y_{12})$

$(X_{41}, Y_{41})$

24

$(X_{21}, Y_{21})$

$(X_{42}, Y_{42})$

22

$(X_{22}, Y_{22})$

# FIG.12

# FIG.13

FIG.14

## FIG.15

## FIG.16

COOLING EXECUTION DEVICE 110

ACQUISITION UNIT ～112

EXECUTION UNIT ～114

PREDICTION UNIT ～116

# FIG.17

IRRADIATION DEVICE ~130

CAMERA 30~ ~140 CAMERA

100 frame/second ~12

CORE ~17

~10

100 frame/second

Central Brain ~15

## FIG.18

# FIG.19

# FIG.20

# FIG.21

(A)

(B)

(C)

●～Xn,Yn

# FIG.22

1200

1212
CPU

1218
DISPLAY DEVICE

1216
GRAPHICS CONTROLLER

1210
HOST CONTROLLER

1214
RAM

1222
COMMUNICATION INTERFACE

1220
INPUT/ OUTPUT CONTROLLER

1224
STORAGE DEVICE

1240
INPUT/ OUTPUT CHIP

1230
ROM

## INTERNATIONAL SEARCH REPORT

International application No.

**PCT/JP2023/038226**

### A. CLASSIFICATION OF SUBJECT MATTER

***B60W 60/00***(2020.01)i; ***B60W 20/14***(2016.01)i; ***B60W 20/50***(2016.01)i; ***B60W 40/02***(2006.01)i; ***B60W 50/04***(2006.01)i; ***G06F 1/20***(2006.01)i; ***G06V 20/58***(2022.01)i; ***H01L 23/473***(2006.01)i; ***H05K 7/20***(2006.01)i

FI: B60W60/00; B60W20/14; B60W20/50; B60W40/02; B60W50/04; G06F1/20; G06V20/58; H01L23/46; H05K7/20

According to International Patent Classification (IPC) or to both national classification and IPC

### B. FIELDS SEARCHED

Minimum documentation searched (classification system followed by classification symbols)

B60W60/00; B60W20/14; B60W20/50; B60W40/02; B60W50/04; G06F1/20; G06V20/58; H01L23/473; H05K7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2018/116840 A1 (HITACHI AUTOMOTIVE SYSTEMS, LTD.) 28 June 2018 (2018-06-28) <br> paragraphs [0011]-[0093], fig. 1-13 | 1-2, 5-6 |

☐ Further documents are listed in the continuation of Box C.  ☑ See patent family annex.

| | |
|---|---|
| \* Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **27 December 2023** | **16 January 2024** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**

International application No.

**PCT/JP2023/038226**

| Box No. III | Observations where unity of invention is lacking (Continuation of item 3 of first sheet) |
| --- | --- |

This International Searching Authority found multiple inventions in this international application, as follows:

Document 1: WO 2018/116840 A1 (HITACHI AUTOMOTIVE SYSTEMS, LTD.) 28 June 2018 (2018-06-28)
    paragraphs [0011]-[0093], fig. 1-13
    & US 2019/0351780 A1, paragraphs [0023]-[0167], fig. 1-13
    & EP 3556588 A1

(Invention 1) Claims 1-2 and 5-6
    Document 1 describes 鮫 cooling device comprising: an acquisition unit for acquiring a detection result of detecting an object relating to the operation of a control device mounted in a vehicle to control autonomous driving of the vehicle; and an execution unit for executing a cooling operation in the control device on the basis of the detection result]. In light of document 1, claim 1 lacks novelty, and thus does not have a special technical feature.
    Meanwhile, although claim 2 that depends from claim 1 has the technical feature wherein "as the detection result, the acquisition unit extracts a point indicating the presence position of an object from a one-frame image of the object, and acquires, at a frame rate of 100 frames/second or greater, movement information indicating the movement, along a predetermined coordinate axis, of the point indicating the presence position of the object", this feature falls within the scope of a mere well-known feature or a mere design matter that could be set, as appropriate, by a person skilled in the art, and thus cannot be considered a special technical feature.
    Claims 5-6 have technical features that are the same as or corresponding to claim 1.
    Accordingly claims 1-2 and 5-6 are classified as invention 1.

(Invention 2) Claims 3-4
    Although claim 3 depends from claim 1 classified as invention 1, the added technical feature relative to claim 1 of [further comprising a prediction unit for using the detection result to predict the operation of the control device, wherein the prediction unit predicts the operation of the control device by using a learning model generated by machine learning using, as training data, the detection result and the operation status of the control device at the time when the detection result has been acquired] has low technical relevance to the technical feature of claim 1 of [comprising: an acquisition unit for acquiring a detection result of detecting an object relating to the operation of a control device mounted in a vehicle to control autonomous driving of the vehicle; and an execution unit for executing a cooling operation in the control device on the basis of the detection result]. Thus, it is not considered that claims 3-4 have an inventive link to claim 1.
    Furthermore, claims 3-4 are not substantially identical to or similarly closely related to any of the claims classified as invention 1.
    Accordingly claims 3-4 cannot be identified as invention 1.
    Meanwhile claims 3-4 have the special technical feature of [further comprising a prediction unit for using the detection result to predict the operation of the control device, wherein the prediction unit predicts the operation of the control device by using a learning model generated by machine learning using, as training data, the detection result and the operation status of the control device at the time when the detection result has been acquired]; thus these claims are classified as invention 2.

(Invention 3) Claims 7-19 and 20-21
    Although claim 7 depends from claim 1 classified as invention 1, the added technical feature relative to claim 1 of [comprising: an acquisition unit for outputting point information in which an object is obtained as a point from an image of the object captured with multiple cameras facing corresponding directions, and recognition information in which the object is recognized, and also acquiring a detection result on the object by an information processing device in which the point information and the recognition information are associated; and an execution unit for executing an operation for cooling the information processing device on the basis of the detection result acquired by the acquisition unit] has low technical relevance to the technical feature of claim 1 of [comprising: an acquisition unit for acquiring a detection result of detecting an object relating to the operation of a control device mounted in a vehicle to control autonomous driving of the vehicle; and an execution unit for executing a cooling operation in the control device on the basis of the detection result]. Thus, it is not considered that claims 7-19 have an inventive link to claim 1.
    Furthermore, claims 7-19 are not substantially identical to or similarly closely related to any of the claims classified as inventions 1 or 2.
    Accordingly claims 7-19 cannot be identified as either of inventions 1 and 2.

## INTERNATIONAL SEARCH REPORT

International application No.

**PCT/JP2023/038226**

| Box No. III | Observations where unity of invention is lacking (Continuation of item 3 of first sheet) |
|---|---|

Meanwhile, claims 7-19 have the special technical feature of [comprising: an acquisition unit for outputting point information in which an object is obtained as a point from an image of the object captured with multiple cameras facing corresponding directions, and recognition information in which the object is recognized, and also acquiring a detection result on the object by an information processing device in which the point information and the recognition information are associated; and an execution unit for executing an operation for cooling the information processing device on the basis of the detection result acquired by the acquisition unit]; thus these claims are classified as invention 3.

Claims 20-21 have technical features that are the same as or corresponding to the special technical feature of claim 7.

Accordingly claims 7-21 are classified as invention 3.

(Invention 4) Claims 22-28

Claims 22-28 share, with claim 1 classified as invention 1, claim 3 classified as invention 2, and claim 7 classified as invention 3, the technical feature of [comprising: an acquisition unit for acquiring a detection result of detecting an object relating to the operation of a control device mounted in a vehicle to control autonomous driving of the vehicle; and an execution unit for executing a cooling operation in the control device on the basis of the detection result]. However, this technical feature does not make a contribution over the prior art in light of the disclosure of document 1, and thus cannot be considered a special technical feature. Apart from this feature, there are not the same or corresponding special technical features among these inventions.

Furthermore, claims 22-28 do not depend from claim 1, claim 3, or claim 7. In addition, claims 22-28 are not substantially identical to or similarly closely related to any of the claims classified as inventions 1-3.

Accordingly claims 22-28 cannot be identified as any of inventions 1-3.

Meanwhile, claims 22-28 have the special technical feature of 鮫 vehicle provided with a control device for controlling autonomous driving, the vehicle including: a power unit including a motor; an acquisition unit for acquiring a detection result of detecting an object relating to the operation of the control device; and an execution unit for executing a cooling operation in the control device on the basis of the detection result, wherein the control device controls parts of the vehicle including the cooling operation by regenerative electric power generated in the motor during deceleration of the vehicle associated with the detection result]; thus these claims are classified as invention 4.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☑ No required additional search fees were timely paid by the applicant. Consequently, this international search report is restricted to the invention first mentioned in the claims; it is covered by claims Nos.: **Claims 1-2 and 5-6**

**Remark on Protest** ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

INTERNATIONAL SEARCH REPORT
Information on patent family members

International application No.

**PCT/JP2023/038226**

| Patent document cited in search report | Publication date (day/month/year) | Patent family member(s) | Publication date (day/month/year) |
|---|---|---|---|
| WO 2018/116840 A1 | 28 June 2018 | US 2019/0351780 A1 paragraphs [0023]-[0167], fig. 1-13 <br> EP 3556588 A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022035198 A
- JP 2022170165 A
- JP 2022172777 A
- JP 2022175679 A
- JP 2022181362 A
- JP 2022182131 A
- JP 2022186040 A
- JP 2022187648 A

- JP 2022187649 A
- JP 2022189546 A
- JP 2022210884 A
- JP 2023036967 A
- JP 2023036975 A
- JP 2023078024 A
- JP 2023080388 A